(19)

Europäisches
Patentamt
European
Patent Office
Office européen
des brevets

(11) **EP 4 068 219 A1**

(12) **EUROPEAN PATENT APPLICATION**

(43) Date of publication:
**05.10.2022  Bulletin 2022/40**

(21) Application number: **21194222.2**

(22) Date of filing: **01.09.2021**

(51) International Patent Classification (IPC):
***G06T 19/00*** *(2011.01)*

(52) Cooperative Patent Classification (CPC):
**G06T 19/00;** G06T 2219/012

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **31.03.2021  JP 2021061633**

(71) Applicant: **FUJIFILM Business Innovation Corp.
Minato-ku
Tokyo (JP)**

(72) Inventors:
• **TAKAHASHI, Tomonari
  Yokohama-shi (JP)**

• **YOKOYAMA, Yuki
  Ebina-shi (JP)**
• **HIGASHIKATA, Ryosuke
  Yokohama-shi (JP)**
• **TANAKA, Yasuyuki
  Yokohama-shi (JP)**
• **OGIHARA, Atsushi
  Ebina-shi (JP)**
• **HIJI, Naoki
  Yokohama-shi (JP)**
• **UEMURA, Yasushi
  Yokohama-shi (JP)**

(74) Representative: **Becker, Eberhard
  Becker Kurig & Partner
  Patentanwälte mbB
  Bavariastraße 7
  80336 München (DE)**

(54) **INFORMATION PROCESSING APPARATUS, INFORMATION PROCESSING PROGRAM, AND INFORMATION PROCESSING METHOD**

(57)    An information processing apparatus includes a processor configured to display a relationship object indicating a positional relationship of at least two or more measurement spots in a molded product at a position corresponding to the relationship on a three-dimensional model of the molded product.

## FIG. 3

EP 4 068 219 A1

**Description**

BACKGROUND OF THE INVENTION

(i) Field of the Invention

The present invention relates to an information processing apparatus, an information processing program, and an information processing method.

(ii) Description of Related Art

JP6735367B discloses a method for correcting a molding die including a product design step of designing a design product model (50) having information on a three-dimensional shape and design values of a product on a product coordinate system that is a preset three-dimensional coordinate system; a forming die creating step of creating a forming die that forms the product on the basis of the design product model (50); a prototype forming step of prototype-form a product using the forming die; a measurement step of measuring the positions of a plurality of measurement points in the prototype-formed product on a measurement coordinate system that is the preset three-dimensional coordinate system; a deviation information calculation step of calculating the size of a deviation between a measurement value of the measurement point measured in the measurement step and a design value of a point on the design product model (50) corresponding to the measurement point; a display step of displaying a drawing showing the shape of the product of the design product model (50) and the size of the deviation on a display unit (26) ; a reference adjustment step of adjusting the position of the product coordinate system such that the size of the deviation at the measurement point becomes small; a deviation information recalculation step of calculating the size of the deviation with respect to the design value in the product coordinate system after the adjustment; and a forming die correction step of correcting the forming die such that the position of the product coordinate system on the product is the position of the product coordinate system after the adjustment in the reference adjustment step. In the reference adjustment step, the product coordinate system is adjusted such that the sum of the sizes of the deviations at the measurement points becomes small. In the reference adjustment step, a partial best fit in which the amount of movement of the product coordinate system is calculated such that the sum of the sizes of the deviations at the selected measurement points becomes small, and an overall best fit in which the amount of movement of the product coordinate system is calculated such that the sum of the sizes of the deviations at all the measurement points becomes small are provided. Within the value of the amount of movement resulting from the partial best fit, the value of the movement amount resulting from the overall best fit, an intermediate value between the movement amount resulting from the partial best fit and the movement amount resulting from the overall best fit, and a range sandwiched between the movement amount resulting from the partial best fit and the movement amount resulting from the overall best fit, values obtained by changing the weighting of the amount of movement a plurality of times are simultaneously calculated. From the calculation result group, a worker selects one calculation result in consideration of a method of correcting the forming die and adjusts the product coordinate system on the basis of a value based on the selected calculation result.

SUMMARY OF THE INVENTION

In a case where a molded product is manufactured, it is complicated to compare a design drawing, various inspection results entered in an inspection table, and a three-dimensional model, and to grasp the finished state of the molded product in the mind. In particular, in a case where the acceptance/rejection of one standard based on the relationship between a plurality of measurement spots in a molded product is determined, and in a case where a plurality of standards interact with each other, it is extremely difficult to grasp at a glance the relationship between the plurality of measurement spots in the molded product.
An object of the present invention is to provide an information processing apparatus, an information processing program, and an information processing method that make it possible to visually recognize the positional relationship of at least two or more measurement spots in a molded product.
According to a first aspect of the present disclosure, there is provided an information processing apparatus including a processor configured to display a relationship object indicating a positional relationship of at least two or more measurement spots in a molded product at a position corresponding to the relationship on a three-dimensional model of the molded product.
According to a second aspect of the present disclosure, there is provided the information processing apparatus, in which the processor may be configured to display, as the relationship object, a first relationship object indicating a positional relationship of at least two or more measurement spots in the molded product, and a second relationship object indicating a positional relationship between the first relationship object and at least one or more measurement spots in the molded product, at positions corresponding to the relationships on the three-dimensional model of the molded product.

According to a third aspect of the present disclosure, there is provided the information processing apparatus, in which the processor may be configured to display, as the relationship object, a third relationship object indicating a positional relationship of at least two or more measurement spots in the molded product, a fourth relationship object indicating a positional relationship of at least two or more measurement spots in the molded product separately from the third relationship object, and a fifth relationship object indicating a positional relationship between the third relationship object and the fourth relationship object, at positions corresponding to the relationships on the three-dimensional model of the molded product.

According to a fourth aspect of the present disclosure, there is provided the information processing apparatus, in which the relationship object may display the positional relationship by forming a line or face including two or more measurement spots.

According to a fifth aspect of the present disclosure, there is provided the information processing apparatus, in which the positional relationship may be acquired by a measurement based on an analog technique.

According to a sixth aspect of the present disclosure, there is provided the information processing apparatus, in which the positional relationship may be acquired from a coordinate position obtained by measuring two or more measurement spots in the molded product.

According to a seventh aspect of the present disclosure, there is provided the information processing apparatus, in which the processor may be configured to acquire design information on a design of the molded product and acquire comparison information obtained by comparing the design information with the positional relationship.

According to an eighth aspect of the present disclosure, there is provided the information processing apparatus, in which the processor may be configured to display at least one of a quantity of a difference or a direction of the difference, which is a result obtained by comparing the positional relationship with the design information, in a color or an arrow that is the relationship object.

According to a ninth aspect of the present disclosure, there is provided the information processing apparatus, in which the measurement spots may be acquired from a position of a center of gravity of a shape element that is an inspection target in the molded product.

According to a tenth aspect of the present disclosure, there is provided the information processing apparatus, in which the processor may be configured to independently display a plurality of the relationship objects on the first inspection target for every plurality of corresponding measurement spots of the first inspection target and the second inspection target in a case where a plurality of the measurement spots are present in each of a first inspection target and a second inspection target in the molded product.

According to an eleventh aspect of the present disclosure, there is provided the information processing apparatus, in which the processor may be configured to compare the first inspection target with the second inspection target, and determine a display position of the relationship object in accordance with a position of a center of gravity of the smaller inspection target in a case where a plurality of the second inspection targets corresponding to the first inspection target are present.

According to a twelfth aspect of the present disclosure, there is provided the information processing apparatus, in which the processor may be configured to display at least one of the design information or the comparison information possessed by the relationship object in a case where the relationship object is selected.

According to a thirteenth aspect of the present disclosure, there is provided the information processing apparatus, in which the processor may be configured to display, simultaneously with the relationship object, another relationship object related to another inspection, which is performed on the inspection target and are also related to the comparison information.

According to a fourteenth aspect of the present disclosure, there is provided the information processing apparatus, in which the processor may be configured to display a plurality of the relationship objects in a manner that the relationship objects are capable of being distinguished from each other.

According to a fifteenth aspect of the present disclosure, there is provided the information processing apparatus, in which the processor may be configured to filter and display the relationship object to be displayed on the three-dimensional model among all the relationship objects related to the molded product.

According to a sixteenth aspect of the present disclosure, there is provided the information processing apparatus, in which the processor may be configured to display the three-dimensional model as a simplified model by combining a plurality of planes and displays the relationship object with an arrow at a corresponding position of the simplified model.

According to a seventeenth aspect of the present disclosure, there is provided the information processing apparatus, in which the processor may determine a reference value used for an acceptance/rejection determination of the molded product, which is calculated on the basis of the design information, in correspondence with a user's selection or attribute information possessed by the user.

According to an eighteen aspect, there is provided an information processing program making a computer display a relationship object indicating a positional relationship of at least two or more measurement spots in a molded product, at a position corresponding to the relationship on a three-dimensional model of the molded product.

According to a nineteenth aspect of the present disclosure, there is provided an information processing method including displaying a relationship object indicating a positional relationship of at least two or more measurement spots in a molded product, at a position corresponding to the relationship on a three-dimensional model of the molded product.

According to the information processing apparatus, it is possible to visually recognize the positional relationship of at least two or more measurement spots in the molded product on the three-dimensional model of the molded product.

According to the information processing apparatus according to the second aspect, it is possible to visually recognize the positional relationship between the relationship object and at least one or more measurement spots in the molded product on the three-dimensional model of the molded product.

According to the information processing apparatus according to the third aspect, it is possible to visually recognize not only the positional relationship of at least one or more measurement spots in the molded product but also the positional relationship between the relationship objects on the three-dimensional model of the molded product.

According to the information processing apparatus according to the fourth aspect, by displaying the relationship object by forming a line or face including the two or more measurement spots, it is possible to more clearly visually recognize the positional relationship of at least two or more measurement spots in the molded product on the three-dimensional model of the molded product.

According to the information processing apparatus according to the fifth aspect, it is also possible to visually recognize the positional relationship of at least two or more measurement spots in the molded product obtained by a measurement result based on the analog technique on the three-dimensional model of the molded product.

According to the information processing apparatus according to the sixth aspect, it is also possible to visually recognize the positional relationship of at least two or more measurement spots in the molded product acquired by the result of three-dimensional measurement using three-dimensional coordinates on the three-dimensional model of the molded product.

According to the information processing apparatus according to the seventh aspect, by obtaining a result obtained by comparing a design standard with the finished state of an actual molded product, it is possible to more accurately grasp the relationship between the positional relationships of at least two or more measurement spots in the molded product.

According to the information processing apparatus according to the eighth aspect, by displaying a result obtained by comparing a design standard with the finished state of an actual molded product in a color or an arrow, it is possible to intuitively grasp the relationship between the positional relationships of at least two or more measurement spots in the molded product.

According to the information processing apparatus according to the ninth aspect, by specifying the measurement spots from the position of the center of gravity of the shape element that is an inspection target, the relationship between the positional relationships of at least two or more measurement spots in the molded product can be more clearly grasped.

According to the information processing apparatus according to the tenth aspect, even in a case where the first inspection target and a plurality of second inspection targets for the first inspection target are inspected, it is possible to visually recognize the positional relationships between the first inspection target and the plurality of second inspection targets on the three-dimensional model of the molded product, respectively.

According to the information processing apparatus according to the eleventh aspect, since the relationship objects are disposed in accordance with the position of the center of gravity of the smaller inspection target, it is possible to prevent the plurality of relationship objects from being overlappingly displayed on the identical three-dimensional model, and it is possible to clearly check the finished state of the molded product.

According to the information processing apparatus according to the twelfth aspect, at least one of information on a standard having a relationship between the first inspection target and the second inspection target or information on an actual finished state is displayed. Accordingly, it is possible to more easily grasp the relationship between the positional relationships of at least two or more measurement spots in the molded product and the finished state.

According to the information processing apparatus according to the thirteenth aspect, not only, by allowing the positional relationship of at least two or more measurement spots in the molded product to be visually recognized on the three-dimensional model of the molded product but also by displaying, simultaneously with the relationship object, another standard and relationship that may interact with each other, it is possible to grasp the relationships between the standards of the entire molded product.

According to the information processing apparatus according to the fourteenth aspect, by displaying the relationship object representing the positional relationship of at least two or more measurement spots in the molded product and another relationship object in which identical inspection targets may interact with each other in such a manner that the relationship objects can be distinguished from each other, it is possible to more easily grasp the relationship between the standards of the entire molded product.

According to the information processing apparatus according to the fifteenth aspect, by displaying only a relationship object that is required to be visually recognized by the user on the three-dimensional model of the molded product, it is possible to reduce the information, which is less required to be visually recognized, from the three-dimensional model, and it is possible to more easily grasp the positional relationship of at least two or more measurement spots in the molded product and the finished state of the entire molded product.

According to the information processing apparatus according to the sixteenth aspect, by expressing the three-dimensional model of the molded product with a further simplified model, it is possible to grasp the finished state of the entire molded product as a tendency.

According to the information processing apparatus according to the seventeenth aspect, by changing the reference value used for the acceptance/rejection determination of the standard of the molded product in accordance with the attributes of users who perform work, such as a designer and a worker in charge of inspection, it is possible to display the acceptance/rejection determination based on the relationship between the positional relationships of at least two or more measurement spots in the molded product, which are appropriate for the users who perform different kinds of work, in a flexible manner.

According to the information processing program according to the eighteen aspect, it is possible to visually recognize the positional relationship of at least two or more measurement spots in the molded product on the three-dimensional model of the molded product.

According to the information processing method according to the nineteenth aspect, it is possible to visually recognize the positional relationship of at least two or more measurement spots in the molded product on the three-dimensional model of the molded product.

BRIEF DESCRIPTION OF THE DRAWINGS

Exemplary embodiment(s) of the present invention will be described in detail based on the following figures, wherein:

Fig. 1 is a diagram showing a display example of relationship objects by an information processing apparatus 10;
Fig. 2 is a block diagram showing a hardware configuration of the information processing apparatus 10;
Fig. 3 is a block diagram showing a functional configuration of the information processing apparatus 10;
Fig. 4 is a diagram showing an example of design information;
Fig. 5 is a diagram showing a display example of a relationship object 33;
Fig. 6 is a diagram showing another example of the relationship object 33;
Fig. 7 is a diagram showing still another example of the relationship object 33;
Fig. 8 is a diagram showing a display example of a second relationship object 34;
Fig. 9 is a diagram showing a display example of a fifth relationship object 35;
Figs. 10A and 10B are diagrams showing a display example of the relationship object 33 using an arrow object;
Fig. 11 is a diagram showing an example of a reference value used for the acceptance/rejection determination of a molded product 30;
Fig. 12 is a flowchart showing the processing of the information processing apparatus 10 according to the exemplary embodiment of the invention;
Fig. 13 is a diagram showing an example of the relationship object 33 having a guide line 36;
Fig. 14 is a diagram showing a display example of the relationship object 33 as auxiliary information;
Fig. 15 is a diagram showing a display example of the relationship object 33 in a case where a plurality of inspection targets 31 are present as inspection targets for a first inspection target 31;
Fig. 16 is a diagram showing a display example of another relationship object 33 that interacts with a certain relationship object 33;
Fig. 17 is a diagram showing a display example of a relationship object XX representing a contour degree;
Fig. 18 is a flowchart showing the processing of the information processing apparatus 40;
Fig. 19 is a diagram showing a display example of a three-dimensional model representing the entire molded product 30;
Fig. 20 is a simplified view showing the inspection targets 31 of the molded product 30 shown in Fig. 19;
Fig. 21 is a diagram displaying only inspection items in a direction perpendicular to a datum A, on the three-dimensional model of the molded product 30 shown in Figs . 19 and 20;
Fig. 22 is a diagram displaying only relationship objects having a rejection determination on the three-dimensional model of the molded product 30 shown in Fig. 19;
Fig. 23 is a diagram displaying only relationship objects having long dimensions on the three-dimensional model of the molded product 30 shown in Fig. 19;
Fig. 24 is a diagram displaying the three-dimensional model of the molded product 30 as a simplified model by combining a plurality of planes; and

Fig. 25 is a flowchart showing the processing of the information processing apparatus 60.

DETAILED DESCRIPTION OF THE INVENTION

Hereinafter, example of embodiments according to the disclosed technique will be described in detail with reference to the drawings.

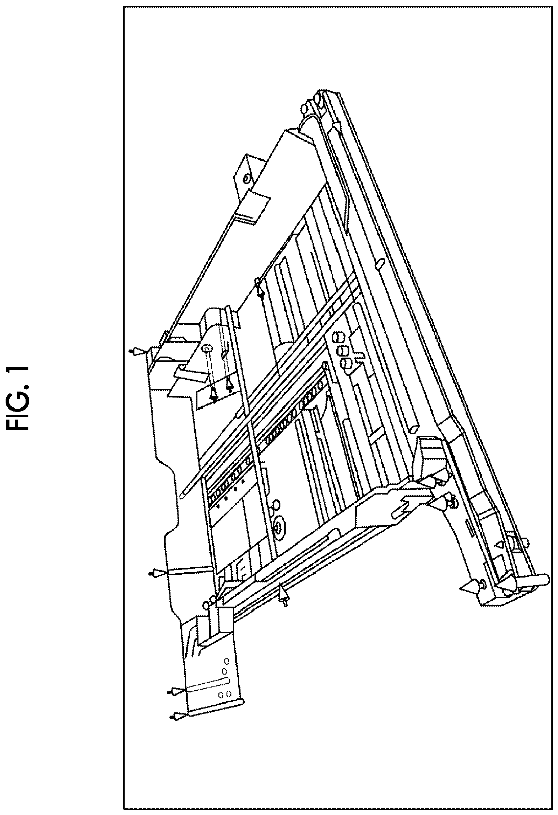

Fig. 1 is a diagram showing a display example by an information processing apparatus 10 according to the exemplary embodiment of the invention.

In the display example shown in Fig. 1, objects representing the positional relationship of at least two or more measurement spots in a molded product are overlappingly displayed on a three-dimensional model of the molded product. As shown in Fig. 1, the information processing apparatus 10 is one in which the objects indicating the relationship between at least two or more measurement spots in the molded product are used and displayed at the positions of the measurement spots of inspection targets in the molded product in various inspections. Hereinafter, objects representing the positional relationship of at least two or more measurement spots in the molded product will be expressed as relationship objects. In Fig. 1, the relationship objects are displayed on the three-dimensional model of the molded product in such a manner that objects of three-dimensional lines, spheres, and three-dimensional arrows are used.

The portions of the molded product serving as the inspection targets and the measurement spots are connected by the relationship objects displayed by the three-dimensional lines shown in Fig. 1. The relationship objects represent the positional relationship between at least two or more measurement spots related to a certain inspection among various inspections performed on the basis of the standards related to the design of the molded product.

The standards related to the design of the molded product are structural definitions that are defined at the design stage of the molded product. Specifically, the standards are datums serving as references for the entire molded product, nominal dimensions that define the size and angle of shape elements in the molded product, tolerances (general tolerances/dimensional tolerances/geometric tolerances) of how much manufacturing variations are allowed with respect to the nominal dimensions, reference information for defining the base points of the nominal dimensions, manufacturing note information, and the like. Hereinafter, points, lines, or faces serving as the inspection references in the design of the molded product are expressed as the datums . It is desirable that the molded product is manufactured according to the standards, for example, and the molded product is manufactured according to the standards. The standards are information included in a part of the design information described below.

The three-dimensional arrow objects are displayed as parts of the relationship objects, for example, in a case where the standards are distances or angles and the corresponding inspection targets are datums, the three-dimensional arrow objects are additionally displayed. In other words, in the case of distances or angles that are based on the datums, which are the absolute reference positions for the standards, regardless of the finish of the molded product, the three-dimensional arrow objects are additionally displayed as parts of the relationship objects. Of course, the arrow objects are not prohibited from being displayed in the case of relative distances or angles that are not based on the datums. For example, three-dimensional arrow objects having inward arrows may be displayed in a case where the relative distances are approaching, and three-dimensional arrow objects having outward arrows may be displayed in a case where the relative distances are far away. Hereinafter, the three-dimensional arrow objects are expressed as arrow objects.

For example, arrow objects whose arrow tips face the molded product in a perpendicular direction may represent that molded products have differences in the arrow directions of the arrow objects in a case where original nominal dimensions defined by the standards are compared with the dimensions of an actually manufactured molded product. Additionally, the sizes of the arrow objects may be proportional to the amounts of differences and the sizes of the differences from the nominal dimensions defined by the standards.

However, not only the arrow objects show inspection results, and all the arrow objects are not necessarily displayed on the relationship objects. Except for the above-described cases, the inspection results are displayed the colors that are the relationship objects. The details of how to show the results of a single relationship object in a case where the arrow obj ects are not displayed will be described below.

The three-dimensional model of the molded product is a three-dimensionally expressed model of a molded product created on the basis of the design information in a three-dimensional coordinate system. The three-dimensional model of the molded product may be a three-dimensional model in which inspection information on the molded product is given to the three-dimensional model created at the design stage. Even any of the diverted models that are not created for display on the information processing apparatus 10 according to the exemplary embodiment of the invention but created at the design stage is included in the three-dimensional model of the molded product when the information on the inspection results of the molded product are added. Moreover, the three-dimensional model of the molded product may be a model created by measuring the molded product after manufacture with a coordinate measuring machine.

In this way, the information processing apparatus 10 according to the exemplary embodiment of the invention allows the positional relationship of at least two or more measurement spots in the molded product to be grasped with at least one of the color or arrow objects that are the relationship objects by using the relationship objects displayed on the three-dimensional model of the molded product.

Next, the outline of the entire system including the information processing apparatus 10 will be described. Although not shown, the information processing apparatus 10 is connected to a client terminal, an input device, and an output device. These devices are connected to a network and are communicable with each other via the network. As an example, the Internet, a local area network (LAN), a wide area network (WAN), and the like are applied to this network.

The information processing apparatus 10 acquires information on the design of the molded product and the information on the inspection results, which are input through the input device.

The client terminal transmits various instructions on the display of the three-dimensional model of the molded product to the information processing apparatus 10. As an example, these various instructions include an instruction to start reading the information on the design of the molded product and the information on the inspection results, an instruction to display results obtained by reading the information on the design of the molded product and the information on the inspection results, and the like. Additionally, the client terminal displays various information processed by the information processing apparatus 10 depending on received various instructions. As an example, a server computer, or a general-purpose computer device such as a personal computer (PC) is applied to the client terminal. The number of client terminals connected to the information processing apparatus 10 is not limited to one, and a plurality of the client terminals may be prepared, and as an example, each client terminal may be separately used for each processing.

The input device inputs the information on the design of the molded product and the information on the inspection results to the information processing apparatus 10. As an example, a server computer, a general-purpose computer device such as a PC, an image forming apparatus having a scanning function, a printer function, and a FAX function, or the like is applied to the input device. In addition, the information on the design of the molded product and information on various measurement results including the inspection results may also be input from the client terminal in addition to the input device to the information processing apparatus 10. The inspection results input by the input device are not limited to digital measurement using the coordinate measuring machine, but also include inspection results by analog measurement. In a case where the inspection results by analog measurement are input, the inspection results may be input via an inspection table.

The output device is a display or the like and displays the three-dimensional model of the molded product on the basis of the instructions of the information processing apparatus 10. In addition, a touch panel in which the output device and the input device are integral with each other may be connected to the information processing apparatus 10.

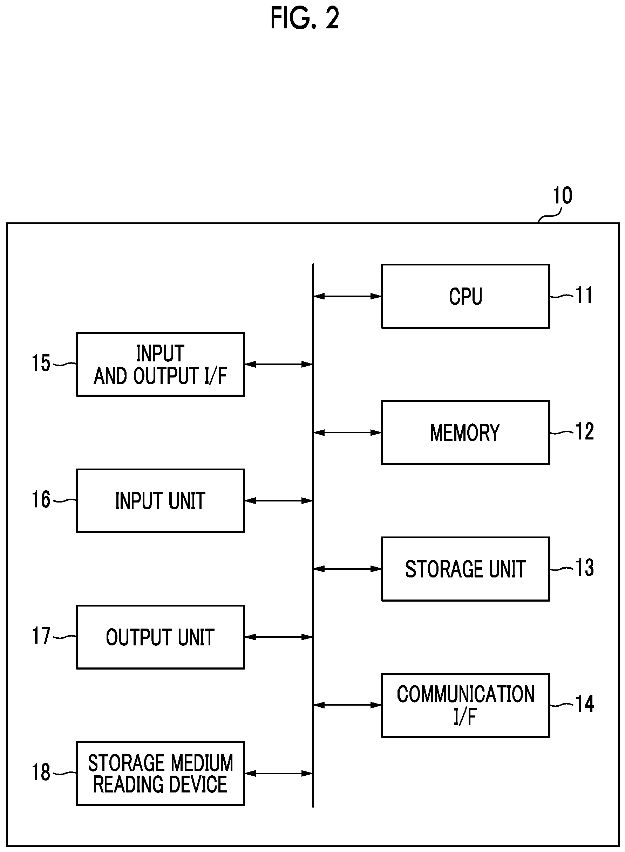

Next, a hardware configuration of the information processing apparatus 10 according to the exemplary embodiment of the invention will be described. Fig. 2 is a block diagram showing the hardware configuration of the information processing apparatus 10 according to the exemplary embodiment of the invention.

As shown in Fig. 2, the information processing apparatus 10 includes a central processing unit (CPU) 11, a memory 12, a storage unit 13, a communication interface (I/F) 14, an input and output I/F 15, an input unit 16, an output unit 17, and a storage medium reading device 18.

The CPU 11 is a central arithmetic processing unit that executes various programs and controls the respective components. That is, the CPU 11 reads out a program from the storage unit 13 and executes the program using the memory 12 as a work area. The CPU 11 controls the above respective components and performs various arithmetic processing in accordance with the programs stored in the storage unit 13.

The memory 12 is constituted by a random access memory (RAM) and temporarily stores a program and data as a work area. The storage unit 13 is constituted by a read only memory (ROM), a hard disk drive (HDD), a solid state drive (SSD), and the like, and stores the various programs including an operating system and various data.

The communication I/F 14 is an interface for communicating with other devices. For example, standards such as Ethernet (registered trademark), FDDI, and Wi-Fi (registered trademark) are used for the communication I/F.

The input and output I/F 15 is an interface that connects the information processing apparatus 10 and an external device to each other. In the exemplary embodiment of the invention, the information processing apparatus 10 is connected to an external input device or the like via the input and output I/F 15.

The input unit 16 is configured to perform various inputs of, for example, a keyboard, a mouse, and the like. The output unit 17 is configured to output, for example, the display of the three-dimensional model of the molded product to the client terminal or the like.

The storage medium reading device 18 reads data stored in various storage media such as a compact disc (CD)-ROM, a digital versatile disc (DVD)-ROM, a Blu-ray disc, and a universal serial bus (USB) memory and writes data to the storage media.

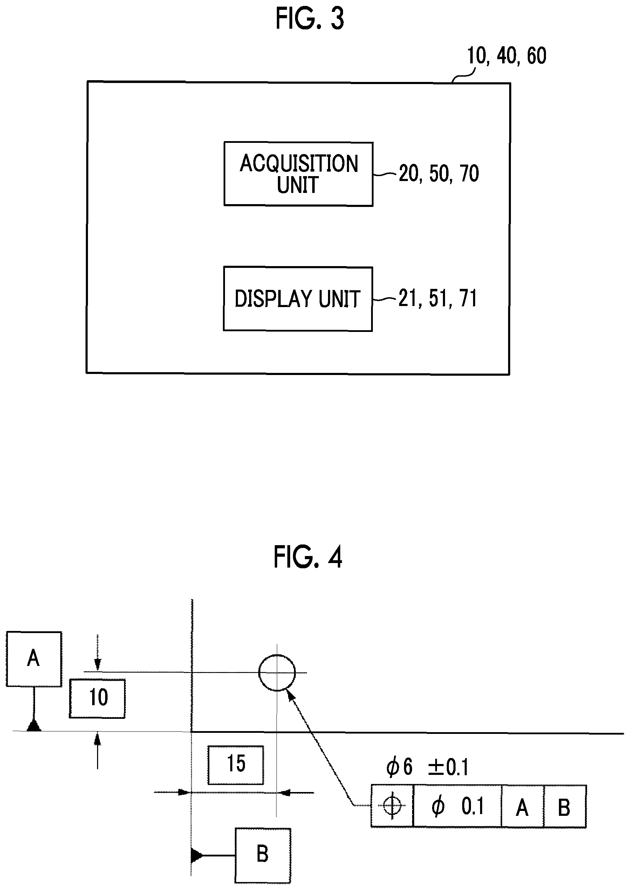

Next, a functional configuration of the information processing apparatus 10 according to the exemplary embodiment of the invention will be described. Fig. 3 is a block diagram showing the functional configuration of the information processing apparatus 10.

As shown in Fig. 3, the information processing apparatus 10 includes an acquisition unit 20 and a display unit 21 as the functional configuration.

The acquisition unit 20 receives the design information of the molded product and the information on the inspection results by the input device.

The molded product is a product processed in a certain shape and is, for example, an object such as an industrially mass-produced part such as a tray shown in Fig. 1. There are various types of die molding such as injection molding and casting for filling a space enclosed by a mold with a material to solidify the material, press forming for pressing a sheet-like material with a die to deform the shape of the material, machining using performed by a cutting machine, welding using an arc or laser, and additional manufacturing performed by a 3D printer. However, any molded objects are within an applicable range of the information processing apparatus 10 according to the exemplary embodiment of the invention.

The design information of the molded product is information on the structure of an object predetermined in manufacturing the molded product. The design information is information that describes the shape, structure, and dimensions of the molded product in accordance with certain rules, has the standards that are the above-described structural definitions, and serves as indexes in a case where the molded product is manufactured.

Fig. 4 is a diagram showing an example of the design information. Fig. 4 shows a part of a molded product in which a circular hole is provided on a certain face. In a case where the molded product is manufactured, how to determine the position of this circular hole is determined by the design information. In the example of Fig. 4, this hole is specified to be provided around a position 10 mm away from a datum A and 15 mm away from a datum B in a case where processing or measuring is performed. Moreover, in Fig. 4, information on the geometric tolerance of the position of the circular shape and the diameter of the circle is also defined as an example of the design information. In manufacturing the molded product, for example, it is desirable that the molded product is manufactured in accordance with predetermined design information, and in a case where the product deviates from the allowable error for the dimensions defined in the design information, the molded product is regarded as defective. The design information shown in Fig. 4 is simplified design information, and the design information may be expressed in three-dimensional coordinates in advance.

The information on the inspection results of the molded product is information on the inspection results of the actually manufactured molded product. The inspection is the act of determining the acceptance/rejection of the standard of an inspection target, which is a target shape, on the basis of a measured single numerical value or a combination of a plurality of measured numerical values. As a result of this acceptance/rejection determination, it is necessary to take some measures for the next stage of manufacture, such as adjusting or correcting the forming conditions, for the inspection target that has been rejected. The inspection is performed on the basis of the design information and allows "how much difference there is" to be checked by comparing the actual dimensions of the molded product with the dimensions defined in the design information.

The differences between the actual dimensions of the molded product and the dimensions defined in the design information include quantity and direction. The inspection includes also the inspection performed by an analog technique in addition to the inspection performed by the coordinate measuring machine that acquires three-dimensional coordinates by directly bringing an inspection probe into contact with the molded product serving as an inspection target and the inspection performed on three-dimensional coordinates by the coordinate measuring machine or the like that acquires the three-dimensional coordinates in a non-contact manner by optical image acquisition. The reflection of the inspection results by the analog technique will be described below.

Additionally, the measurement is the act of acquiring values such as the position, length, and angle of the inspection target, which is the target shape, in the molded product, using a measuring device regardless of whether the technique of the measurement is an analog technique or a digital technique.

The display unit 21 displays the relationship objects indicating the positional relationship of at least two or more measurement spots in the molded product at positions corresponding to the relationship on the three-dimensional model of the molded product.

The measurement spots are points representing specific positions in the molded product used to display the results obtained by measuring or inspecting the molded product on the three-dimensional model. The points indicating the positions of the datums used for the measurement or inspection of the molded product are also included in the measurement spots inside the molded product, and there is also a case where the datums are defined outside the molded product.

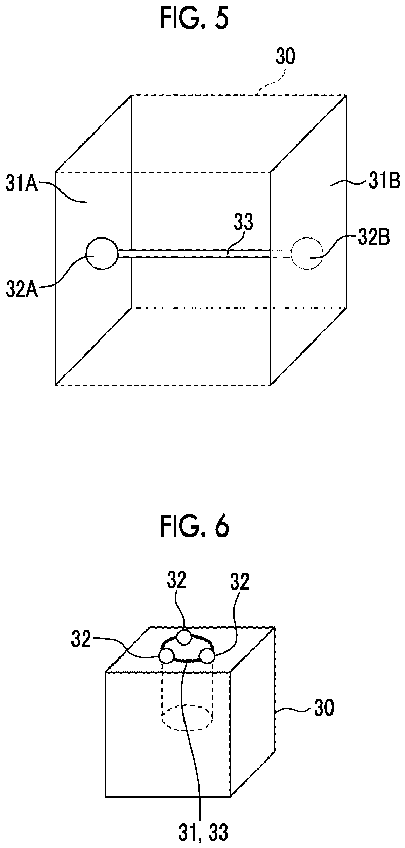

Fig. 5 shows a display example of a relationship object. A molded product 30 represented by a cube is shown in Fig. 5. As for the molded product 30, it is assumed that the positional relationship between a face 31A and a face 31B of the cube is defined in the design information. For example, in a case where the design information defines that the distance between the face 31A and the face 31B is a predetermined distance, the actual distance between the face 31A and the face 31B becomes an inspection target. For that reason, in Fig. 5, the positional relationship between the face 31A and the face 31B is expressed by a relationship object 33. Hereinafter, the face 31A in Fig. 5 will be expressed as a first inspection target 31A, and the face 31B will be expressed as a second inspection target 31B.

Either a measurement spot 32A (hereinafter referred to as a first measurement spot 32A) in the first inspection target 31A or a measurement spot 32B (hereinafter referred to as a second measurement spot 32B) in the second inspection target 31B may be a datum. In a case where the measurement spot is a datum, the result of measurement thereof is generally used in common for the entire molded product 30. For example, in a case where the first measurement spot 32A is the datum A, the inspection targets 31 other than the datum, which are based on the datum A, are respectively inspected on the basis of a plurality of measurement results based on the correspondence relationship between the first measurement spot 32A and an N1th measurement spot 32N1, between the first measurement spot 32A and an N2th measurement spot 32N2, and between the first measurement spot 32A and an N3th measurement spot 32N3.

The relationship object 33 is an object expressed on the three-dimensional model of the molded product 30 indicating the positional relationship between the measurement spot 32A in the first inspection target 31A and the measurement spot 32B in the second inspection target 31B. The relationship object 33 is shown so that a user can grasp at a glance that a certain inspection has been performed on a positional relationship between the measurement spots.

Fig. 6 is a diagram showing another example of the relationship object 33. Here, three measurement spots 32 are present in the inspection target 31 of the molded product 30. The three measurement spots 32 are respectively points for measuring the circumference of a cylindrical portion having a columnar shape, which is the inspection target 31 of the molded product 30. In this way, even in a case where the inspection target 31 is one and the plurality of measurement spots 32 are present on the one inspection target 31, it is possible to display the relationship object 33 indicating the positional relationship between the respective measurement spots 32 present on the inspection target 31. In Fig. 6, the inspection target 31 is the circumference of the cylindrical portion having the columnar shape, and the relationship object 33 represents the positional relationship of the plurality of measurement spots 32 present on the circumference of the cylindrical portion having the columnar shape. Therefore, in this case, the inspection target 31 and the relationship object 33 indicate the identical circumference. However, a circle that constitutes a part shape as an inspection target and a circle of a relationship object that represents the positional relationship of measurement spots have different meanings.

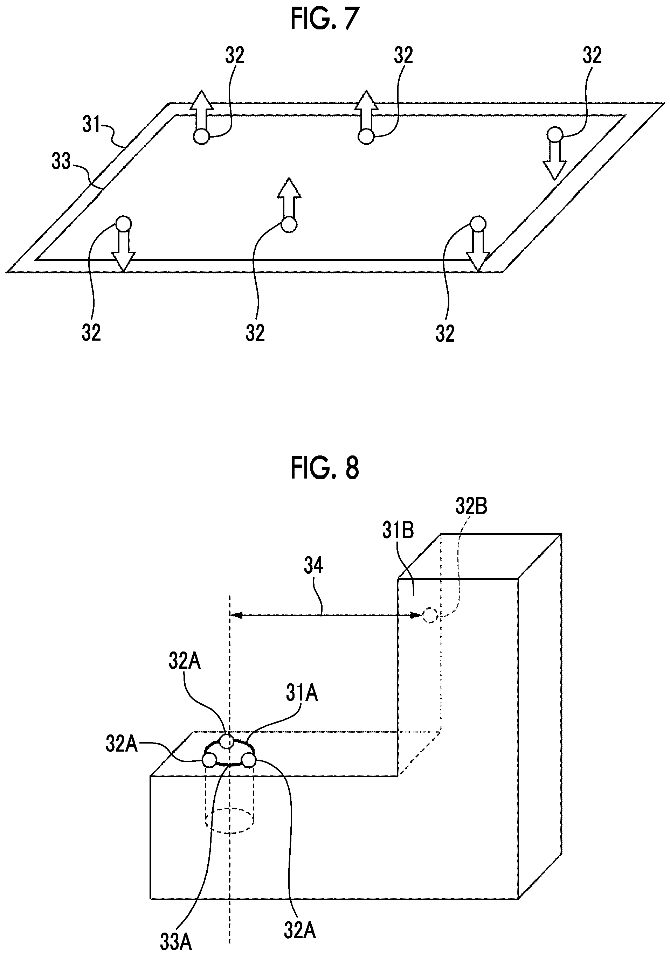

Fig. 7 is a diagram showing still another example of the relationship object 33. Here, the shape of the relationship object 33 in a case where the relationship object 33 is displayed by connecting a plurality of measurement spots 32 will be described. Fig. 7 shows a display example of the relationship object 33 in a case where the contour degree of a face that is the inspection target 31 is inspected on the basis of the results obtained by measuring six measurement spots 32 on the identical inspection target 31. The relationship object 33 shown in Fig. 7 is a quadrangular plane. In this way, the relationship object 33 is not necessarily limited to one obtained by expressing the positional relationship between the measurement spots 32 by connecting the measurement spots 32 with three-dimensional lines. As shown in Fig. 7, the relationship object 33 may be an approximate plane derived from each measurement spot 32 or may be the plane itself that is the inspection target 31. Additionally, the relationship object 33 may be a minimum circumscribing rectangle of each measurement spot 32 or may be a shape slightly smaller than the plane that is the inspection target 31.

In addition, as described above, the relationship object 33 is not limited to the one indicating the positional relationship between the two or more measurement spots 32. As relationship objects, the display unit 21 may display a first relationship object 33A indicating the positional relationship of at least two or more measurement spots 32 in the molded product 30, and a second relationship object 34 indicating the positional relationship of the first relationship object 33A and at least one or more measurement spots 32B in the molded product 30.

Additionally, the display unit 21 may display the first relationship object 33 indicating the positional relationship of at least two or more measurement spots 32 in the molded product 30, and the second relationship object 34 indicating the positional relationship between the first relationship object 33 and at least one or more measurement spots 32 in the molded product 30, at the positions corresponding to the relationships on the three-dimensional model of the molded product 30.

Fig. 8 is a diagram showing a display example of the second relationship object 34. The second relationship objects 34 indicates the positional relationship between the first relationship objects 33 and at least one or more measurement spots 32 in the molded product 30. In Fig. 8, an inspection target 31A is present as the first inspection target 31 and an inspection target 31B is present as the second inspection target 31. The first relationship object 33A indicating a central axis of a circumference, which is the positional relationship of three measurement spots 32A, is displayed on the circumference of a cylindrical portion that is the first inspection target 31A. The first relationship object 33A in the example of Fig. 8 indicates the central axis of the circumference of the inspection target 31A, which is shown by a broken line. Meanwhile, one measurement spot 32B is present in the second inspection target 31B. In this way, even a positional relationship where one is the first relationship object 33A and the other is the measurement spot 32B can be displayed as the second relationship object 34.

Still another aspect can also be considered as the relationship object 33. As the relationship object 33, the display unit 21 may display a third relationship object 33A indicating the positional relationship of at least two or more measurement spots 32 in the molded product 30, a fourth relationship object 33B indicating the positional relationship of at least two or more measurement spots 32 in the molded product 30 separately from the third relationship object 33A, and a fifth relationship object 35 indicating the positional relationship between the third relationship object 33A and the fourth relationship object 33B.

Additionally, the display unit 21 displays the third relationship object 33A indicating the positional relationship of at least two or more measurement spots 32 in the molded product 30, the fourth relationship object 33B indicating the positional relationship of at least two or more measurement spots 32 in the molded product 30 separately from the third relationship object 33A, and the fifth relationship object 35 indicating the positional relationship between the third relationship object 33A and the fourth relationship object 33B, at the positions corresponding to the above relationships on the three-dimensional model of the molded product 30.

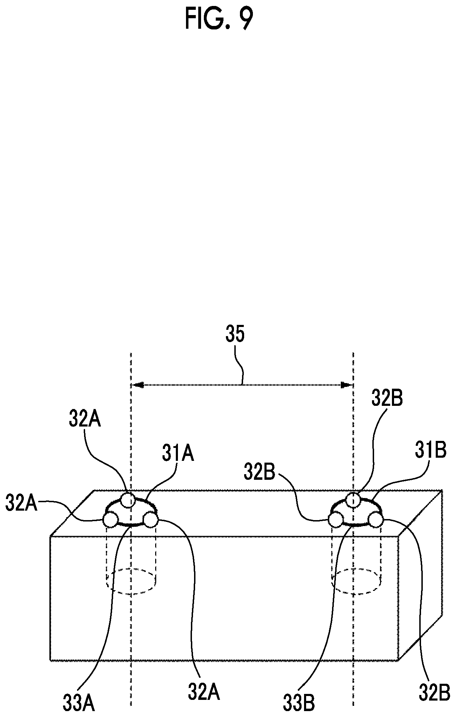

Fig. 9 is a diagram showing a display example of the fifth relationship object 35. The fifth relationship objects 35 indicates the positional relationship between the third relationship object 33A and the fourth relationship object 33B. In Fig. 9, the inspection target 31A is present as the first inspection target 31 and the inspection target 31B is present as the second inspection target 31. The third relationship object 33A indicating a central axis of a circumference, which is the positional relationship of the three measurement spots 32A, is displayed on the circumference of a cylindrical portion that is the first inspection target 31A. The third relationship object 33A in the example of Fig. 9 indicates the central axis of the circumference of the inspection target 31A, which is shown by a broken line. Meanwhile, also in the second inspection target 31B, the fourth relationship object 33B indicating a central axis of a circumference, which is the positional relationship of three measurement spots 32B, is displayed on the circumference of a cylindrical portion. The fourth relationship object 33B in the example of Fig. 9 indicates the central axis of the circumference of the inspection target 31B, which is shown by a broken line. In this way, even a positional relationship where one displays the third relationship object 33A and the other displays the fourth relationship object 33B can be displayed as the fifth relationship object 35.

As described above, the first relationship object 33A, the second relationship object 34, and the fifth relationship object 35 have been described as various aspects of the relationship object 33. In the following, in a case where it is not necessary to express the first relationship object 33A, the second relationship object 34, and the fifth relationship object 35 in a particularly distinguished manner, these relationship objects are collectively and simply expressed as "relationship objects 33".

In this way, the display unit 21 can display the relationship object 33 even in a case where a plurality of measurements are performed. For example, even in a case where there is one measurement spot 32 for each of two inspection targets 31 (first inspection target 31 and second inspection target 31), that is, the measurement spots 32 are one-to-one, even in a case where measurement spots 32 for the two inspection targets 31 (first inspection target 31 and second inspection target 31) are 1 to N, and even in a case where the measurement spots 32 for the two inspection targets 31 (first inspection target 31 and second inspection target 31) are N to N, it is possible to display the positional relationship of two or more measurement spots 32 in each inspection target 31 in the molded product 30 by passing through the relationship object 33. In this way, the display unit 21 according to the exemplary embodiment of the invention can indicate a positional relationship based on a combination of various relationship objects 33.

Additionally, the acquisition unit 20 acquires a measurement spot 32 from the position of the center of gravity of the shape element of the inspection target 31 in the molded product 30.

The display unit 21 displays the relationship object 33 at the measurement spot 32 acquired by the acquisition unit 20. As for the measurement spot 32 acquired by the acquisition unit 20, in a case where the coordinate measuring machine or the like is used, the three-dimensional coordinates measured on the three-dimensional model may be used as the measurement spot 32. Additionally, in a case where a position to be measured on the basis of the design information is specified, the position may be used as the measurement spot 32. The position of the center of gravity of the inspection target 31 may be used as the measurement spot 32 at the time of analog measurement described below, in a case where the three-dimensional coordinates measured by the coordinate measuring machine cannot be acquired, or the like. The measurement spots 32 are specified not only at the position of the center of gravity of the inspection target 31 but also at a position where a measurement is actually performed in the inspection target 31, and at a position where there is an instruction for a measurement position in the inspection target 31.

Additionally, the display unit 21 forms a line or a face including two or more measurement spots 32 to display the positional relationship of at least two or more measurement spots 32 in the molded product 30.

For example, since the relationship object 33 in Fig. 5 indicates the positional relationship between the first inspection target 31A and the second inspection target 31B, the first inspection target 31A and the second inspection target 31B are shown by being connected to each other with three-dimensional lines. As shown in Fig. 5, in a case where the first inspection target 31A and the second inspection target 31B are connected to each other with lines, the relationship object 33 connects the measurement spot 32A of the first inspection target 31A and the measurement spot 32B of the second inspection target 31B with a line.

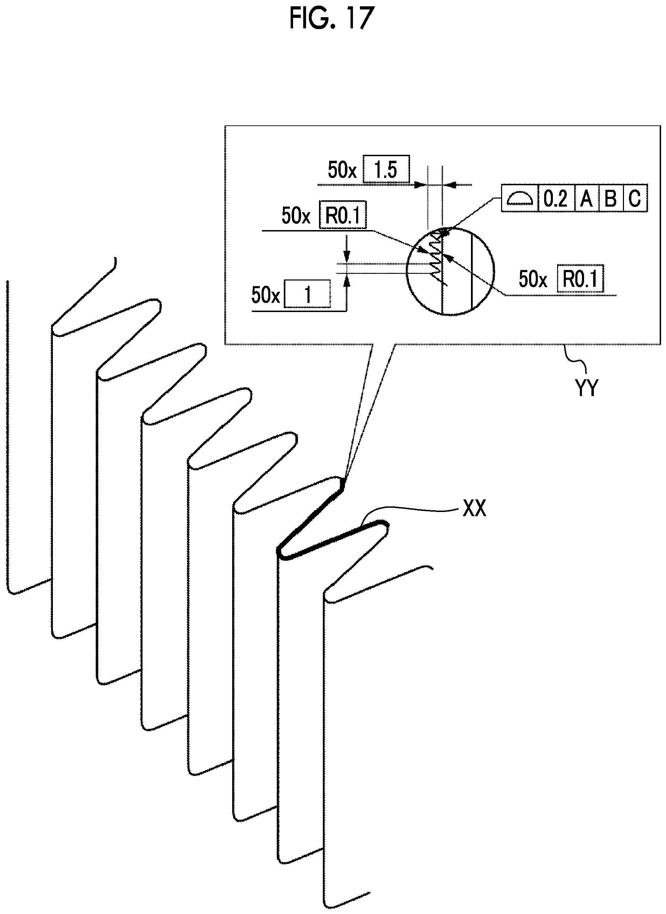

In a case where the display unit 21 displays the relationship object 33, there are expression methods such as generating a plane including the measurement spots 32 as shown in Fig. 7 and duplicating parts such as a line and a face having a shape serving as the inspection target 31 as shown in Fig. 17 described below, in addition to connecting the plurality of measurement spots 32 in the molded product 30 to each other with a three-dimensional line as shown in Fig. 5. The display mode of the relationship object 33 is not limited to the examples given here.

Additionally, the acquisition unit 20 can also acquire the positional relationship of at least two or more measurement spots 32 in the molded product 30 by measurement by the analog technique.

The measurement based on the analog technique is not the measurement of the molded product 30 using the three-dimensional coordinates obtained by an optical 3D scanner, a stylus type coordinate measuring machine, or the like, but measuring an actual molded product 30 by using a ring gauge, a micrometer, a caliper, a pin gauge, a cylindrical taper gauge, a chamfer gauge, an angle gauge, a feeler gauge, or the like. Since the results of measurement by such an analog technique are usually recorded in a table format, it takes a long time to associate the measurement results at the measurement spots 32 of the molded product 30 with each other in the mind. However, by causing the acquisition unit 20 to associate the measurement spots 32 recorded in the table with the corresponding positions of the molded product 30 on the three-dimensional model, thereby specifying the position of each inspection target 31 in the actual molded product 30, the acquisition unit 20 also acquires various measurement results recorded in a table format, which are obtained by the analog technique.

Since the ring gauge and the pin gauge are means for evaluating the size of the diameter, the gauges are substantially equivalent to measuring a plurality of measurement spots 32 in terms of diameter. Additionally, similarly, the micrometer, the caliper, the cylindrical taper gauge, the chamfer gauge, the angle gauge, and the feeler gauge are also means for measuring a distance or an angle between a plurality of measurement spots 32.

For example, the inner diameter or outer diameter of a circle cannot be determined without measuring at least three spots in three-dimensional coordinates. However, in a case where a gauge is used, the inner diameter or outer diameter of the circle can be inspected with a single measurement. In a case where a gap is three-dimensional coordinates, the gap cannot be determined unless at least two or more spots are measured. However, in a case where a gauge is used, the gap can be inspected with a single measurement. In this way, in the measurement based on the analog technique, the plurality of measurement spots 32 in the plurality of inspection targets 31 are measured with a single measurement. Therefore, the inspection results acquired by the measurement based on the analog technique are also included in the inspection results in the exemplary embodiment of the invention.

Additionally, the acquisition unit 20 acquires the positional relationship of at least two or more measurement spots 32 in the molded product 30 from the coordinate positions obtained by measuring the two or more measurement spots 32 in the molded product 30. Similarly, also in the measurement of the molded product 30 using the three-dimensional coordinates by the coordinate measuring machine or the like, the relationship object 33 can be displayed in correspondence with the measurement positions on the three-dimensional model of the molded product 30.

Additionally, the acquisition unit 20 acquires design information related to the design of the molded product 30 and acquires comparison information comparing the design information with the positional relationship.

The acquisition unit 20 compares the acquired design information on the design of the molded product 30 with the positional relationship of at least two or more measurement spots 32 in the actually manufactured molded product 30 and acquires the comparison results as the comparison information. For example, in Fig. 5, in a case where the fact that the positional relationship between the first inspection target 31A and the second inspection target 31B is 10 mm apart is defined as the design information, it is assumed that the positional relationship between the measurement spot 32A of the first inspection target 31A and the measurement spot 32B of the second inspection target 31B in the actually manufactured molded product 30 is 9.8 mm apart. In this case, the acquisition unit 20 acquires comparison information that the positional relationship between the first inspection target 31A and the second inspection target 31B is at a distance that is 0.2 mm shorter than the design information.

There are two types of comparison information acquired by the acquisition unit 20. The first is information in which the design information is compared with the measurement results . As in the example of Fig. 5 described above, the acquisition unit 20 acquires the information that the positional relationship between the first inspection target 31A and the second inspection target 31B is at a distance that is 0.2 mm shorter than the design information, as the comparison information, as a result of comparing the design information with an actual measurement result.

Secondly, the acquisition unit 20 also acquires information in which the above-described first comparison information is compared with an allowable range, as the comparison information. It is extremely rare that all molded products 30 are manufactured according to the design information. In most cases, the allowable range is provided for the difference from the design information. The allowable range is a range that defines how much difference is required to determine an acceptance for the difference between the design information and the actual measurement result in performing an acceptance/rejection determination by inspection. For example, in Fig. 5, it is assumed that the allowable range of the distance between the first inspection target 31A and the second inspection target 31B is defined as ± 0.4 mm of the design information. In this example, the acquisition unit 20 acquires comparison information that the distance between the first inspection target 31A and the second inspection target 31B is at a distance that is 0.2 mm short, as a result of already comparing the actual measurement result. For that reason, the acquisition unit 20 acquires comparison information that a difference (0.2 mm) in distance between the first inspection target 31A and the second inspection target 31B is within the allowable range (± 0.4 mm), on the basis of the result obtained by comparing the design information acquired by the comparison information with the actual measurement result. Details of the allowable range will be further described below.

Additionally, the display unit 21 displays the quantity or direction of a difference that is a result obtained by comparing the positional relationship of at least two or more measurement spots 32 in the molded product 30 with the design information in a color or an arrow that is the relationship object 33.

On the basis of the result obtained by comparing the positional relationship of at least two or more measurement spots 32 in the molded product 30 with the design information, which is acquired by the acquisition unit 20, the display unit 21 displays the quantity or direction of the difference between the design information and the actually manufactured molded product 30 in a color or an arrow that is the relationship object 33.

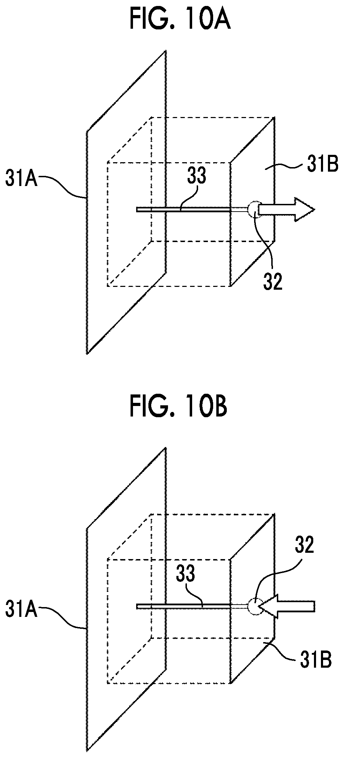

Figs. 10A and 10B are diagrams showing a display example of the relationship object 33 using an arrow object. In Figs. 10A and 10B, the positional relationship between the first measurement spot 32A and the second measurement spot 32B is displayed by the relationship object 33. In the example shown in Fig. 10A, a case where the positional relationship between the first measurement spot 32A and the second measurement spot 32B is at a position that is farther than the design information as a result of comparing the actually manufactured molded product 30 with the design information is shown. In this case, as shown in Fig. 10A, the relationship object 33 is displayed with an arrow object faces a direction opposite to the first measurement spot 32A from the second inspection target 31B. This is to make it possible to visually grasp at a glance that the positional relationship between the first measurement spot 32A and the second measurement spot 32B is too far away than the design information.

Meanwhile, in the example shown in Fig. 10B, a case where the positional relationship of at least two or more measurement spots 32 in the molded product 30 is at a position that is closer than the design information as a result of comparing the actually manufactured molded product 30 with the design information is shown. In this case, as shown in Fig. 10B, the relationship object 33 is displayed by an arrow object facing the direction from the second inspection target 31B to the first inspection target 31A. This is to make it possible to visually grasp at a glance that the positional relationship between the first inspection target 31A and the second inspection target 31B is too close than the design information. In this way, the display unit 21 displays the quantity or direction of the difference that is a result obtained by comparing the positional relationship between the first inspection target 31A and the second inspection target 31B with the design information, with the relationship object 33 using an arrow object.

Moreover, the display unit 21 may display the quantity of difference that is a result obtained comparing the positional relationship of at least two or more measurement spots 32 in the molded product 30 with the design information in a color applied to the relationship object 33. For example, a case where the positional relationship of at least two or more measurement spots 32 in the actually manufactured molded product 30 exceeds an upper limit of the allowable range with respect to a standard value and the allowable range that are determined in advance as the design information is displayed in red, and a case where the positional relationship falls below a lower limit of the allowable range is displayed in blue. Here, the standard value is a value that is predetermined in advance as the design information.

In a case where the magnitude of the absolute amount of the difference that is the result obtained by comparing the positional relationship of at least two or more measurement spots 32 in the molded product 30 with the design information is expressed in the color applied to the relationship object 33, there is also a case where whether or not the positional relationship of at least two or more measurement spots 32 in the actually measured molded product 30 is within the allowable range is represented in the color applied to the relationship object 33. For example, as a result of comparing the positional relationship of at least two or more measurement spots 32 in the molded product 30 with the design information, the difference may be expressed in a cold color such as blue in a case where the difference is within the allowable range, and the difference may be expressed in a warm color such as red with the intention of calling attention to the user in a case where the difference exceeds the allowable range.

Additionally, the method in which the display unit 21 displays the result obtained by comparing the positional relationship of at least two or more measurement spots 32 in the molded product 30 with the design information is not limited to the method using the arrow object, and the compared result may be displayed with a single object. Additionally, the comparison information on the quantity of difference compared with the design information may be represented only in the color of the relationship object 33.

Specifically, the difference between the positional relationship of at least two or more measurement spots 32 in the actually measured molded product 30 and the standard value, and the difference in how far the positional relationship of at least two or more measurement spots 32 in the actually measured molded product 30 is from the allowable range may be represented only in the color of the relationship object 33. In this case, for example, the difference may be displayed in green in a case where the difference is within the allowable range with a margin, the difference may be displayed in yellow with the intention of calling attention in a case where the difference is within the allowable range but the difference is a difference close to the range limit, and the difference may be displayed in red with the intention of warning that the threshold has been exceeded in a case where the difference even slightly exceeds the allowable range.

As another example, the difference may be displayed in gradation colors from a cold color system to a warm color system as the difference is farther from the standard value as the absolute value. For example, the difference is displayed in orange in a case where the difference slightly exceeds the standard value, the difference is displayed in red in a case where the difference greatly exceeds the standard value, the difference is displayed in light blue in a case where the difference slightly falls below the standard value, or the difference is displayed in blue in a case where the difference greatly falls below the standard value. Accordingly, it is possible to more accurately grasp the positional relationship between the two or more measurement spots 32 in the molded product 30 at a glance, and it is possible to easily grasp the finished state of the molded product 30.

As still another example, the difference may be displayed with the deformation of a shape from a straight line to a wavy line or from a circle to a polygon as the difference is farther from the standard value as the absolute value. For example, the difference may be expressed with a wavy line having a small amplitude and a large wavelength or a polygon having only a convex obtuse angle in a case where the standard value is slightly exceeded, and the difference may be expressed with a wavy line having a large amplitude and a small wavelength or a star-shaped polygon obtained by combining a convex acute angle and a concave acute angle with each other in a case where the difference greatly exceeds the standard value. Of course, the difference may be displayed by combining colors in addition to the deformation of the shape. The expression method for the quantity or direction of the difference between the design information and the actually manufactured molded product 30 is not limited to the examples given here.

Additionally, the comparison information acquired by the acquisition unit 20 is not limited to the information in which the aforementioned standard value is compared with the positional relationship of at least two or more measurement spots 32 in the molded product 30. There is also a case where the information obtained by comparing a reference value described below with the positional relationship of at least two or more measurement spots 32 in the molded product 30 is provided. In a case where both the comparison information on the standard value and the comparison information on the reference value are present, display methods may be provided, respectively, so that both can be distinguished from each other. Here, the reference value is a numerical value used for determining the direction of the arrow object in terms of processing and for acceptance/rejection determination based on the inspection of the molded product 30.

Additionally, the acquisition unit 20 determines the reference value used for the acceptance/rejection determination of the molded product 30, which is calculated on the basis of the design information, in correspondence with a user's selection or the attribute information possessed by the user.

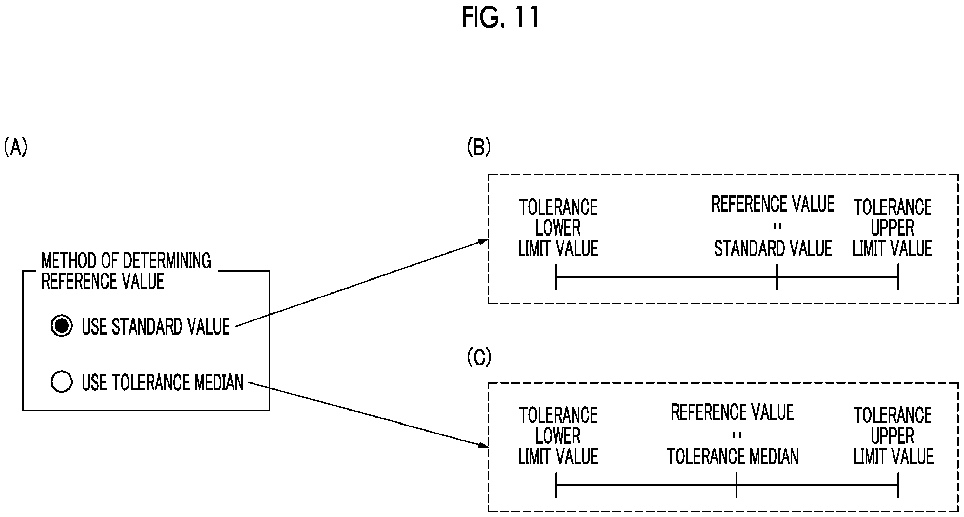

In performing an acceptance/rejection determination on the finished state of the actually manufactured molded product 30, the acquisition unit 20 determines the reference value used for the acceptance/rejection determination in correspondence with the user's selection or the attribute information possessed by the user. Fig. 11 is a diagram showing an example of the reference value used for the acceptance/rejection determination. (A) of Fig. 11 is an example of a display screen for selecting a method of determining the reference value used for the acceptance/rejection determination, which is displayed by the display unit 21. The user selects whether to "use the standard value" or "use a tolerance median" as the reference value used for the acceptance/rejection determination on the basis of the screen of (A) of Fig. 11.

The reference value used for the acceptance/rejection determination is used in a case where the design information is compared with the positional relationship of at least two or more measurement spots 32 in the molded product 30. The result of the comparison affects the display of the arrow object or the relationship object 33 expressed in color. Although repeated, as described above, in manufacturing the molded product 30, it is desirable that the molded product 30 is manufactured according to the design information, for example. However, it is extremely difficult and impractical to manufacture all the molded products 30 according to the design information without any dimensional difference.

For that reason, the allowable range is set in advance for the molded product 30 at the design stage. This allowable range means the range of difference from the design information in which the actually manufactured molded product 30 is recognized to function as the molded product 30 even in a case where the molded product does not follow the design information. The allowable range may be rephrased as a tolerance range . Even in a case where the molded product 30 is not manufactured according to the design information without any dimensional difference, the molded product 30 having a finished state within this allowable range is regarded as an accepted product, and the molded product 30 having a difference exceeding the allowable range is regarded as being rejected and treated as a defective product.

In determining this allowable range, the "standard value" or the "tolerance median" is used as shown in (A) of Fig. 11, and the allowable range has an upper limit and a lower limit. The upper limit and the lower limit are the "tolerance lower limit value" and the "tolerance upper limit value" in (B) of Fig. 11 and (C) of Fig. 11. The two reference values used to determine the "tolerance lower limit value" and the "tolerance upper limit value" are the "standard value" or the "tolerance median". Usually, the three-dimensional model of the molded product 30 is created on the basis of the standard value of a design target. For this reason, the reference value in a case where the performance of the design function is considered is a standard value shown in (B) of Fig. 11. In contrast, in a case where the variations of process capability during mass production, or the like, follow a normal distribution, there is a case where it is desirable to set the reference value to the median of the allowable range of the standard, for example, as shown in (C) of Fig. 11. For that reason, the user is made to specify how to determine the reference value for calculating the difference in conformity with the purpose of use of the user, and the acquisition unit 20 determines the reference value by a specified method.

The selection of the reference value allows the user to specify and switch the "reference value" to be used, in accordance with the purpose of use in order to calculate the difference in each standard of each to the inspection tables to be used, in a case where an arrow object that visualizes warpage or twist, which will be described below, is generated or in a case where an arrow object that represents the difference from the design information as the above-described relationship object 33 is generated.

The attribute information possessed by the user is the work contents that the user who uses the information processing apparatus 10 is in charge of. For example, since the viewpoint of checking the molded product 30 varies depending on whether the user who uses the information processing apparatus 10 is a worker in charge of design or a worker in charge of inspection, the "reference value" is determined in correspondence with the attribute information possessed by the user. The reference value may be set in advance by automatically displaying (B) of Fig. 11 in a case where the user who checks the inspection results is a department in charge that is responsible for the design function and automatically displaying (C) of Fig. 11 in a case where the user is a department in charge that is responsible for the process capability or yield rate during mass production. Additionally, in a case where the results are different from each other for respective reference values, settings may be performed in advance so as to present the need for checking a determination result in another reference value for warning even in a case where the reference values are specified in (B) of Fig. 11 and (C) of Fig. 11. In this way, the determination of the "reference value" can be made by selecting an optional reference value by the user, and can be predetermined in accordance with the attribute information of the user.

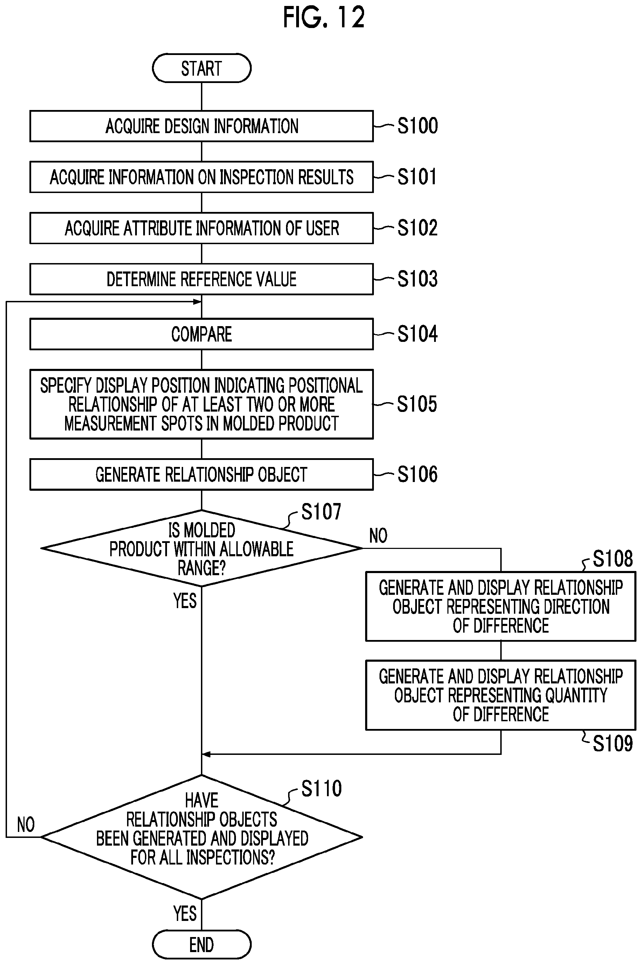

Next, the operation of the information processing apparatus 10 according to the exemplary embodiment of the invention will be described. Fig. 12 is a flowchart showing the processing of the information processing apparatus 10 according to the exemplary embodiment of the invention. The processing of the information processing apparatus 10 according to the exemplary embodiment of the invention is executed by the CPU 11 reading an information processing program stored in the storage unit 13 or the like.

In Step S100, the CPU 11 acquires the design information of the molded product 30 as the acquisition unit 20.

In Step S101, the CPU 11 acquires the information on the inspection results of the molded product 30 as the acquisition unit 20.

In Step S102, the CPU 11 acquires the user's attribute information as the acquisition unit 20.

In Step S103, the CPU 11, as the acquisition unit 20, determines a reference value to be used for acceptance/rejection determination regarding the finished state of the actually manufactured molded product 30.

In Step S104, the CPU 11, as the acquisition unit 20, compares the acquired design information on the design of the molded product 30 with the positional relationship of at least two or more measurement spots 32 in the actually manufactured molded product 30.

InStepS105, the CPU 11, as the display unit 21, specifies a display position indicating the positional relationship of at least two or more measurement spots 32 in the molded product 30.

InStepS106, the CPU 11, as the display unit 21, generates and displays the relationship object 33 at the display position indicating the positional relationship of at least two or more measurement spots 32 in the molded product 30 on the three-dimensional model of the molded product 30.

In Step S107, the CPU 11, as the acquisition unit 20, determines whether or not the actually manufactured molded product 30 has a finished state within the allowable range, as a result of comparing the acquired design information on the design of the molded product 30 and the positional relationship of at least two or more measurement spots 32 in the actually manufactured molded product 30. In a case where the actually manufactured molded product 30 has the finished state within the allowable range, the processing proceeds to Step S109, and in a case where the actually manufactured molded product 30 does not have the finished state within the allowable range, the processing proceeds to Step S108.

In Step S108, the CPU 11, as the display unit 21, generates and displays the relationship object 33 representing the direction of a difference that is a result obtained by comparing the positional relationship acquired by the acquisition unit 20 with the design information.

In Step S109, the CPU 11, as the display unit 21, generates and displays the relationship object 33 representing the quantity of the difference that is the result obtained by comparing the positional relationship acquired by the acquisition unit 20 with the design information.

In Step S110, the CPU 11, as the acquisition unit 20, determines whether or not the relationship objects 33 have been generated and displayed for all the inspections related to the molded product 30 on the basis of the information on the inspection results of the molded products 30. In a case where the relationship objects 33 have been generated and displayed for all the inspections related to the molded product 30, the processing ends, and in a case where the relationship object 33 has not been generated and displayed for all the inspections related to the molded product 30, the processing returns to Step S104.

As described above, according to the information processing apparatus 10 according to the exemplary embodiment of the invention, it is possible to visually recognize the positional relationship of at least two or more measurement spots 32 in the molded product 30 on the three-dimensional model of the molded product 30. Additionally, accordingly, it is possible to visually recognize the finished state of the actually manufactured molded product 30.

In addition, it is also possible to display the relationship object 33 even in a case where the positional relationship of at least two or more measurement spots 32 in the molded product 30 is twisted, that is, even in a case where the positional relationship of at least two or more measurement spots 32 in the molded product 30 is at a twisted position.

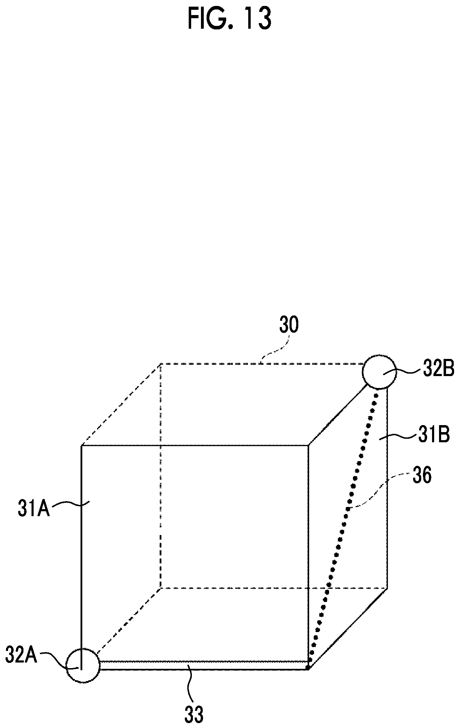

Fig. 13 is a diagram showing an example of the relationship object 33 having a guide line 36. The positional relationship between the measurement spot 32A of the first inspection target 31A and the measurement spot 32B of the second inspection target 31B in the molded product 30 in Fig. 13 is the relationship of a twisted position where the direction of a line connecting the first inspection target 31A and the second inspection target 31B to each other and an inspection direction do not coincide with each other. That is, the positional relationship between the measurement spot 32A of the first inspection target 31A, and the measurement spot 32B of the second inspection target 31B that is neither on the identical straight line nor on the identical plane with respect to the measurement spot 32A of the first inspection target 31A is a relationship in which the length of a certain side of a cube 30 having the measurement spot 32A of the first inspection target 31A and the measurement spot 32B of the second inspection target 31B as apexes is measured.

In the case as shown in Fig. 13, a line extending from the measurement spot 32A of the first inspection target 31A by a length or angle based on the standard in the inspection direction is the main relationship object 33. However, in order to clearly display an actual inspection target 31, a line connecting the other end point of a line that is the main relationship object 33 and the measurement spot 32B of the second inspection target 31B is displayed in combination with the guide line 36 displayed as a dotted line. Whether the line that is the main relationship object 33 is started from either the measurement spot 32A of the first inspection target 31A or the measurement spot 32B of the second inspection target 31B and the guide line 36 is started from which may be determined in advance as one that does not interfere with the three-dimensional model as much as possible.

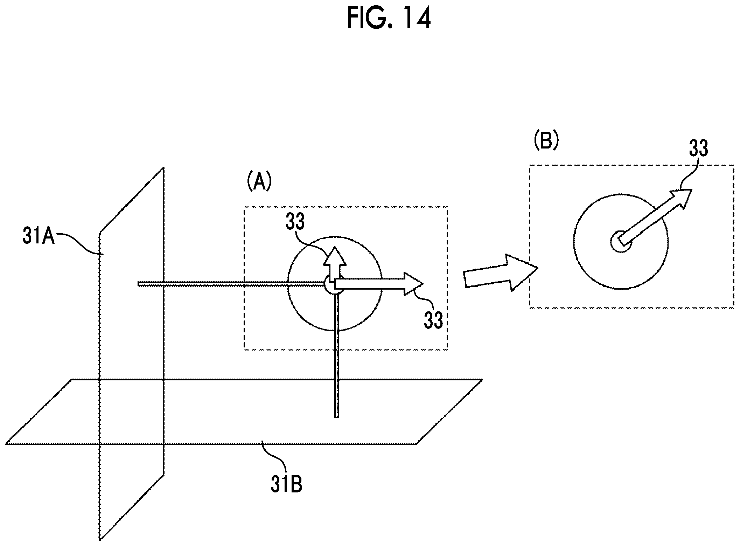

In addition, the display of an arrow object displayed together with the relationship object 33 may not necessarily be accurate display of the direction of a difference according to the result of each inspection. Fig. 14 is a diagram showing a display example of the relationship object 33 as auxiliary information. Fig. 14 shows a three-dimensional model of the molded product 30 manufactured on the basis of the design information shown in Fig. 4. In a case where a circular shape is located at a position farther from the first inspection target 31A and at a position farther from the second inspection target 31B than the design information, as shown in (A) of Fig. 14, the relationship object 33 has two arrow objects on the basis of the respective kinds of comparison information. In this case, since one inspection target 31 is defined as standards based on a plurality of directions, as shown in (B) of Fig. 14, an arrow object having a direction in which a plurality of arrow objects are synthesized may be displayed. Additionally, in this case, in a case where the relationship object 33 is displayed, as shown in (B) of Fig. 14, a central point of the circular shape may be displayed as the auxiliary information of the relationship object 33 in order to easily grasp the position of the circular shape.

<Second exemplary embodiment>

Next, a second exemplary embodiment will be described. In the exemplary embodiment of the invention, a case where a plurality of other inspection targets are present for the first inspection target 31 will be described in detail. In addition, since the information processing apparatus 40 according to the exemplary embodiment of the invention is based on the information processing apparatus 10 according to the first exemplary embodiment, the configuration, functions, operations, and the like that are the same as those of the information processing apparatus 10 according to the first exemplary embodiment will be designated by the same reference numerals as the reference numerals in the first exemplary embodiment, and detailed description thereof will be omitted.

Since the hardware configuration of the information processing apparatus 40 according to the exemplary embodiment of the invention is the same as the hardware configuration of the information processing apparatus 10 according to the first exemplary embodiment shown in Fig. 2, description thereof will be omitted.

As shown in Fig. 3, the functional configuration of the information processing apparatus 40 according to the exemplary embodiment of the invention is also the same as the functional configuration of the information processing apparatus 10 according to the first exemplary embodiment. The information processing apparatus 40 also includes an acquisition unit 50 and a display unit 51 as functional units. Here, only the functions different from the functions of the first exemplary embodiment will be described, and the description of the same functions as the functions of the first exemplary embodiment will be omitted.

In the exemplary embodiment of the invention, the information processing apparatus 40 displays a plurality of relationship objects 33 corresponding to the first inspection target 31. In a case where a plurality of inspection targets 31 are present as other inspection targets for the first inspection target 31, it is also necessary to display a plurality of relationship objects 33.

In a case where a plurality of the measurement spots 32 are present in each of the first inspection target 31 and the second inspection target 31, the display unit 51 independently displays a plurality of the relationship objects 33 on the first inspection target 31 for a plurality of the measurement spots 32 corresponding to each of the first inspection target 31 and the second inspection target 31.

In the exemplary embodiment of the invention, a case where a plurality of inspection targets 31 are present with respect to the first inspection target 31 in a case where at least two or more portions serving as inspection targets are present in the molded product 30 with respect to a certain inspection on the molded product 30 will be described. Hereinafter, the plurality of other inspection targets 31 that are present with respect to the first inspection target 31 are collectively expressed as the second inspection target 31.

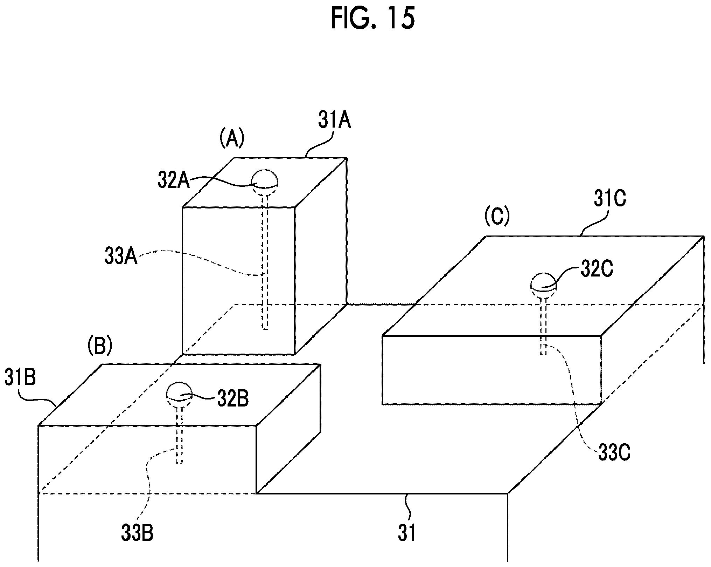

Fig. 15 is a diagram showing a display example of each relationship object 33 in a case where a plurality of other inspection targets 31A, 31B, and 31C are present as inspection targets for the first inspection target 31. The first inspection target 31 may be a datum face that is a reference position of the molded product 30 itself, or a wide face that can be a reference face of a plurality of second inspection targets 31.

Three corresponding inspection targets 31 including (A), (B), and (C) are present in the first inspection target 31 in Fig. 15. (A) is referred to as the second inspection target 31A, (B) is referred to as the second inspection target 31B, and (C) is referred to as the second inspection target 31C. In Fig. 15, for each of the three inspection targets including, the second inspection target 31A, the second inspection target 31B, and the second inspection target 31C, the relationship objects 33A, the relationship objects 33B, and the relationship objects 33C are respectively and independently displayed on the first inspection targets 31. In this way, the relationship between the measurement spot 32 in the first inspection target 31 and the measurement spot 32 in the second inspection target 31 may not necessarily be a one-to-one relationship.

In a case where a plurality of second inspection targets 31 corresponding to the first inspection target 13 are present, the display unit 51 compares the first inspection target 31 with the second inspection targets 31A to 31C and determines the display position of the relationship object 33 in accordance with the position of the center of gravity of a smaller inspection target 31.

In a case where the relationship objects 33 corresponding to the three second inspection targets 31 including (A), (B), and (C) shown in Fig. 15 are for the three-dimensional model and are all displayed in an overlapping manner on the measurement spot 32 of the first inspection target 31, it is difficult to visually grasp the relationship between the three second inspection targets 31 including (A), (B), and (C) and the first inspection target 31. Thus, in the information processing apparatus 40 of the exemplary embodiment of the invention, in a case where a plurality of second inspection targets 31 are present as inspection targets for the first inspection target 31, priority is given to the position where a smaller inspection target 31 is disposed.

In Fig. 15, since the first inspection target 31 is the largest and the second inspection target 31A is smaller than the second inspection target 31B and the second inspection target 31C, the relationship object 33A of the second inspection target 31A is preferentially disposed on the first inspection target 31. Comparing the second inspection target 31B and the second inspection target 31C, the second inspection target 31B is smaller than the second inspection target 31C. Therefore, the relationship object 33B of the second inspection target 31B is disposed in preference to the second inspection target 31C. The reference for comparing the size may be area or volume. Each of the relationship object 33A, the relationship object 33B, and the relationship object 33C are disposed at positions perpendicular to the measurement spot 32, which is the position of the center of gravity of each of the second inspection target 31A, the second inspection target 31B, and the second inspection target 31C.

Additionally, in a case where a relationship object 33 is selected, the display unit 51 displays at least one of the design information or the comparison information possessed by the relationship object 33.

In a case where the user selects any one relationship object 33 of the plurality of relationship objects 33 displayed on the three-dimensional model of the molded product 30, the display unit 51 also displays at least one of the design information or the comparison information of the relationship object 33 on a display screen of another format such as numerical information, in addition to displaying the information as another object such as an arrow object.

Additionally, the display unit 51 displays, simultaneously with the relationship object, another relationship object 33 related to another inspection, which is performed on the inspection target 31 and are also related to the comparison information.

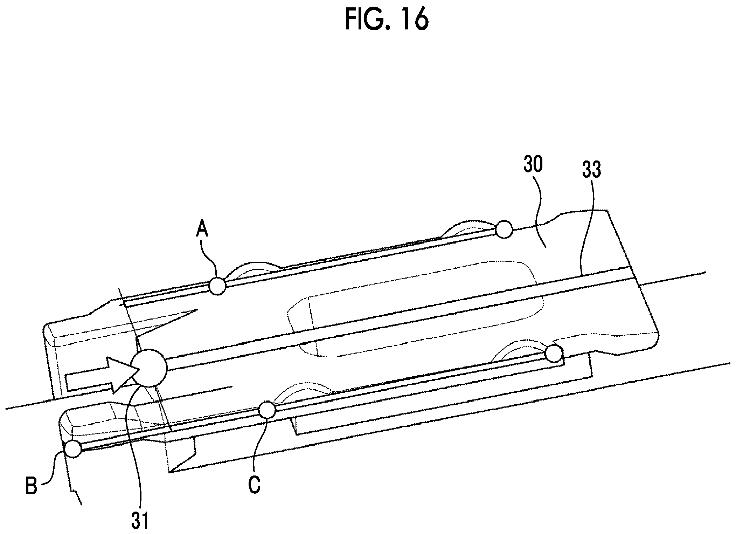

Fig. 16 is a diagram showing a display example of another relationship object 33 that interacts with a certain relationship object 33. In Fig. 16, in a part of the molded product 30, a relationship object 33 displayed at a central portion of Fig. 16 is selected by the user. In this relationship object 33, there are other relationship objects A, B, and C related to the other inspection target 31, which are performed on the identical first inspection target 31 and interact with each other. In Fig. 16, an arrow object is shown in the relationship object 33, which indicates that the arrow object is shorter than the design information in a rightward direction of the drawing. In a case where the position of the first inspection target 31 corresponding to the relationship object 33 is to be corrected on the basis of this, it is also necessary to consider the influence on the other relationship objects A, B, and C for the correction.

For example, in a case where there are a plurality of standards based on the same inspection target 31 in the identical molded product 30, such as in a case where a mold for injection molding is corrected, the correction of the inspection target 31 also changes other related standards. In the related art, the user traces relationships related to a plurality of inspections in his mind while looking at design drawings or the like. However, there is a limit to a range in which the user can grasp the relationship related to each of the plurality of inspections in his mind, and mistakes such as oversights are likely to occur. For that reason, in a case where a certain relationship object 33 on the three-dimensional model of the molded product 30 is selected, another relationship object 33 based on the other inspection target 31 related to the design information is extracted and displayed. Accordingly, the user can visually grasp the relationship between a plurality of inspection results.

Additionally, the relationship object 33 may indicate the contour degree of the inspection target 31. Fig. 17 is a diagram showing a display example of a relationship object XX representing the contour degree of the molded product 30. In Fig. 17, a standard for the contour degree of the geometric tolerance of the inspection target 31 shown in Fig. 17 is defined while being surrounded by a quadrangular balloon YY. In this way, the reference information YY for defining the contour degree is defined in the relationship object XX. The reference information is portions of [1.5], [RO. 1], [1], and [RO 1] surrounded by the quadrangular balloon YY in Fig. 17.

The reference information YY is also referred to as basic dimensions, ideal dimensions, theoretical dimensions, exact dimensions, or, in ISO 1101:2017 (Geometrical product specifications (GPS)), "theoretically exact dimensions (TED)". In order to inspect the contour degree of the shape of a certain inspection target 31, for example, it is necessary to measure a plurality of measurement spots 32, and it is desirable that a relationship object XX for grasping the positional relationship of the plurality of measurement spots 32 is displayed.

As shown in Fig. 17, in a case where the relationship object XX indicating the contour degree is selected, the user extracts and displays the relationship object XX and the reference information YY of the measurement spots 32 of the related reference points. Accordingly, the user can use visually grasp the relationship regarding the contour degree defined on the basis of the plurality of reference points. It is needless to say that the same applies to the standards of other geometric tolerances such as flatness, position, and parallelism other than the contour degree. Additionally, the same applies to angles and sizes other than the geometric tolerances as long as the reference information is defined.

Additionally, the display unit 51 displays the plurality of relationship objects 33 displayed on the three-dimensional model of the molded product 30 in such a manner that the relationship objects can be distinguished from each other. The display unit 51 displays the relationship object 33 selected by the user in such a manner that the relationship object 33 selected by the user can be distinguished from the relationship objects 33 other than the relationship object 33 selected by the user. For example, due to the thickness of a three-dimensional line that is a relationship object 33, the color of a line that is a relationship object 33, and the like, the relationship objects are displayed so as to be capable of being clearly distinguished from each other even in a case where the relationship object 33 selected by the user and the other related relationship objects 33 are simultaneously displayed. In addition, the manner that the relationship objects can be distinguished is not limited to the example given in the exemplary embodiment of the invention.

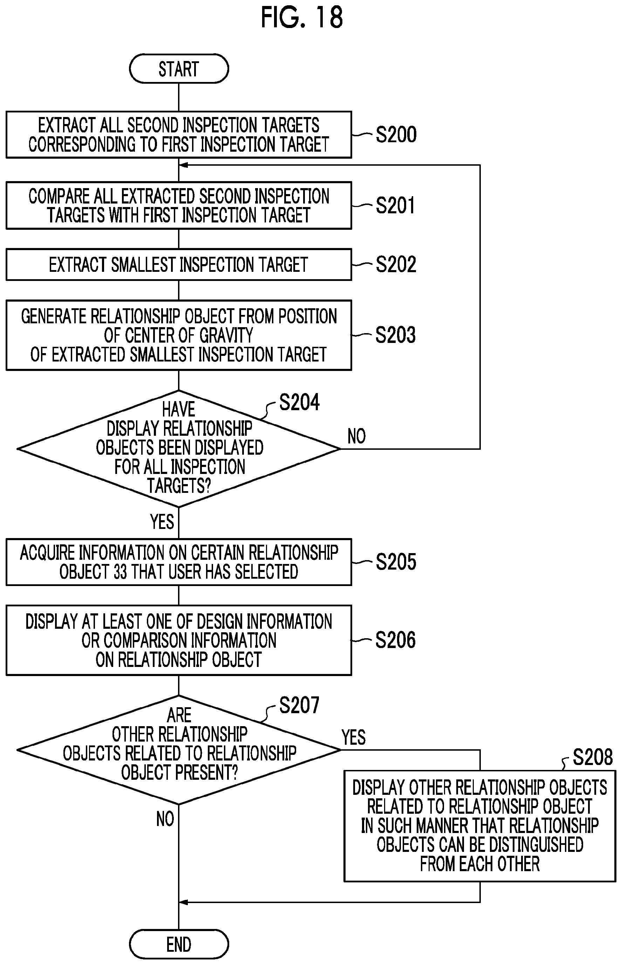

Fig. 18 is a flowchart showing the processing of the information processing apparatus 40 according to the exemplary embodiment of the invention. The description of common points between the processing shown in Fig. 12 and the basic processing of the information processing apparatus 40 according to the exemplary embodiment of the invention will be omitted. Fig. 18 illustrates the processing of the information processing apparatus 40 in a case where there are a plurality of inspection targets 31 corresponding to the first inspection target 31.

In Step S200, the CPU 11, as the acquisition unit 50, extracts all the second inspection targets 31 corresponding to the first inspection target 31.

In Step S201, the CPU 11, as the acquisition unit 50, compares all the extracted second inspection targets 31 with the first inspection target 31.

In Step S202, the CPU 11, as the acquisition unit 50, extracts the smallest inspection target 31 as a result of comparing all the extracted second inspection targets 31 with the first inspection target 31.

In Step S203, the CPU 11, as the display unit 51, generates and displays a relationship object 33 from the position of the center of gravity of the extracted smallest inspection target 31.

In Step S204, the CPU 11, the acquisition unit 50, determines whether or not the relationship objects 33 have been displayed for all the inspection targets 31 extracted in Step S200. As a result of the determination, in a case where the relationship objects 33 are displayed for all the inspection targets 31 extracted in Step S200, the processing proceeds to Step S205. On the other hand, in a case where no relationship object 33 is displayed for all the inspection targets 31 extracted in Step S200, the processing returns to Step S201 and the same processing is repeated until the relationship objects 33 are displayed for all the inspection targets 31 extracted in Step S200.

In Step S205, the CPU 11, as the acquisition unit 50, acquires information on a certain relationship object 33 that the user has selected.

In Step S206, the CPU 11, as the display unit 51, displays at least one of the design information or the comparison information on the relationship object 33 selected by the user in the previous step.

In Step S207, the CPU 11, as the acquisition unit 50, determines whether or not there are other relationship objects 33 related to the relationship objects 33 selected by the user in the previous step. In a case where there are other relationship objects 33 related to the relationship objects 33 selected by the user in the previous step, the processing proceeds to Step S208. In a case where there is no other relationship object 33 related to the relationship object 33 selected by the user in the previous step, the processing ends.

In Step S208, the CPU 11, as the display unit 51, displays other relationship objects 33 related to the relationship object 33 selected by the user in the previous step in such a manner that the relationship objects can be distinguished from each other.

As described above, according to the information processing apparatus 40 according to the exemplary embodiment of the invention, even in a case where there are a plurality of inspection targets 31 as inspection targets for the first inspection target 31, it is possible to visually recognize the positional relationship of at least two measurement spots 32 in the molded product 30 simultaneously on the three-dimensional model of the molded product 30. Additionally, accordingly, since the complicated relationships between the plurality of inspection targets 31 and between the measurement spots 32 in the molded product 30 can be grasped at a glance, it is possible to more clearly visually recognize the finished state of the actually manufactured molded product 30.

<Third exemplary embodiment>

Next, a third exemplary embodiment will be described. In the exemplary embodiment of the invention, a case where all the relationship objects 33 in the molded product 30 are displayed will be described in detail. In addition, since an information processing apparatus 60 according to the exemplary embodiment of the invention is based on the information processing apparatus 10 according to the first exemplary embodiment and the information processing apparatus 40 according to the second exemplary embodiment, the configuration, functions, operations, and the like that are the same as those of the information processing apparatus 10 according to the first exemplary embodiment will be designated by the same reference numerals as the reference numerals in the first exemplary embodiment, and detailed description thereof will be omitted.

Since the hardware configuration of the information processing apparatus 60 according to the exemplary embodiment of the invention is same as the hardware configuration of the information processing apparatus 10 according to the first exemplary embodiment shown in Fig. 2, description thereof will be omitted.

As shown in Fig. 3, the functional configuration of the information processing apparatus 60 according to the exemplary embodiment of the invention is also the same as the functional configuration of the information processing apparatus 10 according to the first exemplary embodiment. The information processing apparatus 60 also includes an acquisition unit 70 and a display unit 71 as functional units. Here, only the functions different from the functions of the first exemplary embodiment and the second exemplary embodiment will be described, and the description of the same functions as the functions of the first exemplary embodiment and the second exemplary embodiment will be omitted.

In the exemplary embodiment of the invention, the information processing apparatus 60 extracts and displays only the information necessary for the user in a case where all the relationship objects 33 in the molded product 30 are displayed.

The display unit 71 filters and displays the relationship objects 33 to be displayed on the three-dimensional model among all the relationship objects 33 related to the molded product 30.

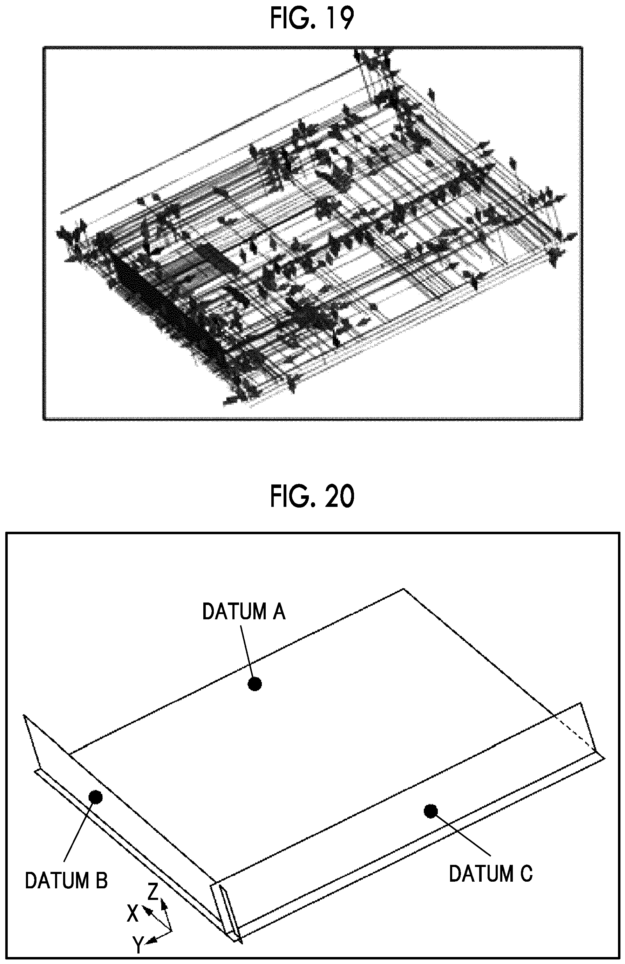

Fig. 19 is a diagram showing an example in which all the relationship objects 33 in the molded product 30 are displayed. As shown in Fig. 19, many inspections are performed on the molded product 30. Therefore, in a case where all the relationship objects 33 in the molded product 30 are displayed, even the relationship objects 33 of spots unrelated to a spot currently intended to be determined are displayed. Therefore, this is complicated and difficult to see. Thus, the information processing apparatus 60 according to the exemplary embodiment of the invention displays only the relationship objects 33 required for the user's work.

Fig. 20 is a simplified view of the inspection targets 31 of the molded product 30 shown in Fig. 19. Fig. 20 is a view of datums serving as references for the inspection the molded product 30 shown in Fig. 19. There are three of these datums. A bottom face of the molded product is referred to as a datum A, a face provided perpendicularly to the datum A on the left side of the drawing is referred to as a datum B, and a face intersecting the datum B at right angles and provided perpendicularly to the datum A is referred to as a datum C.

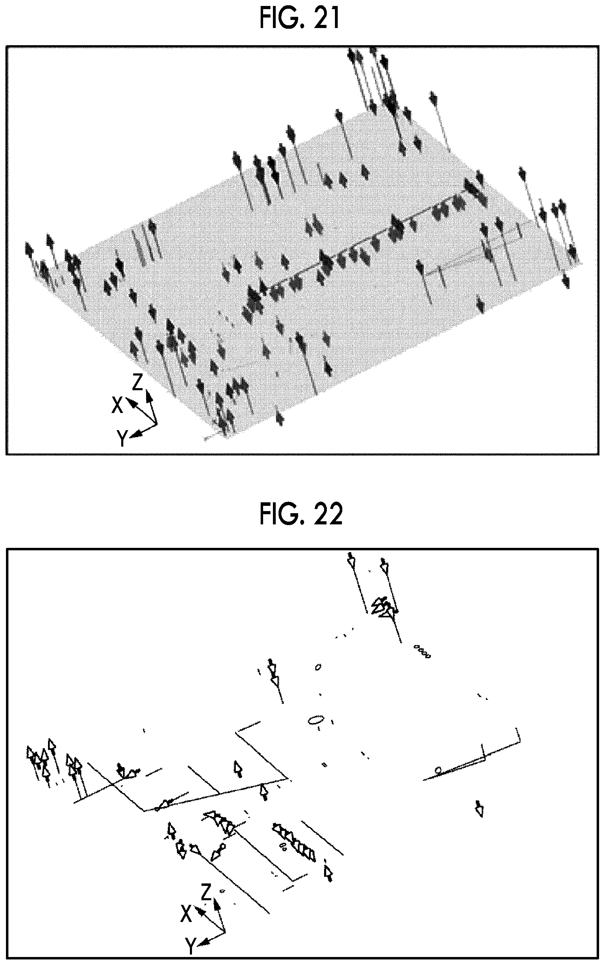

Fig. 21 is a diagram displaying only inspection items in a direction perpendicular to the datum A, on the three-dimensional model of the molded product 30 shown in Figs . 19 and 20. In this way, the display unit 71 omits information other than the information that the user wants to see, and displays only the relationship objects 33 that the user should check. Although not shown, similarly, it is also possible to display only inspection items in the direction perpendicular to the datum B and only inspection items in the direction perpendicular to the datum C. By filtering and displaying the inspection items in the direction of a datum serving as a basis for the inspection items, it is easy to grasp the expansion and contraction of the molded product 30, the tendency of warpage and twist, the distribution of points having many problems in a finished state, and the like.

Fig. 22 is a diagram displaying only relationship objects 33 having a rejection determination on the three-dimensional model of the molded product 30 shown in Fig. 19. As described above, each of the relationship objects 33 has the comparison information, and an acceptance/rejection determination is performed on the basis of a reference value determined by the user. As a result of the acceptance/rejection determination, only the relationship objects 33 that deviate from the allowable range and are determined to be rejected are extracted and displayed. Accordingly, the display of the relationship objects 33 that have relatively no problem can be omitted, and attention can be paid to only determination results having problems. Even in a case where a determination result is determined to be acceptable, in a case where the determination result exceeds a predetermined threshold such as the reference value, the determination result may be rejected with a slight change and may be filtered as a determination that calling attention is required. For example, the above filtering is filtering of only relationship objects 33 having inspection results exceeding 90% of the allowable range.

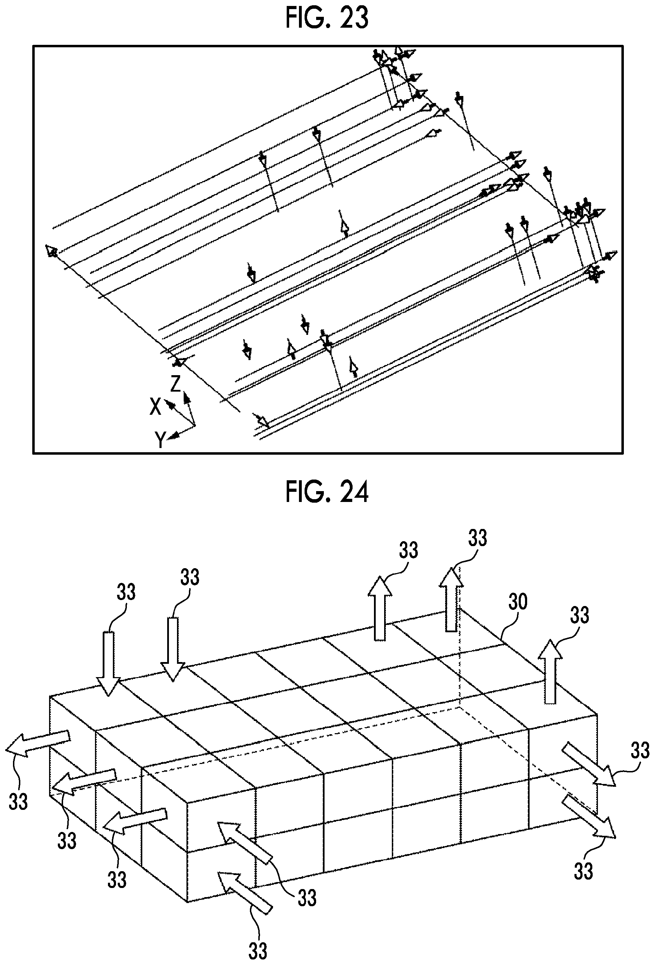

Fig. 23 is a diagram displaying only relationship objects 33 having long dimensions on the three-dimensional model of the molded product 30 shown in Fig. 19. In this way, by displaying only the relationship objects 33 having long dimensions in the molded product 30, it is easy to check the tendency of expansion and contraction of the entire molded product 30.

Only corresponding relationship objects 33 may be displayed at points clearly flagged as meaningful references by the user in charge of design, spots related to geometric tolerances that often serve as meaningful standards for function and assembly, or the like as the filtering references, in addition to the references given in the above-described example. Alternatively, filtering may be performed for points having tolerances set to be stricter than the general tolerances, or filtering may be performed for every measuring means, every measurer, or every measurement date for measurement assistance. In addition, the filtering references are not limited to the examples given here.

In a case where the user selects the relationship objects 33 to be displayed from all the relationship objects 33 displayed on the three-dimensional model of the molded product 30, there are various variations in the display of a screen for selecting filtering. For example, the relationship objects 33 may be selected by a selection screen separately displayed by the display unit 71 displayed outside a screen on which the three-dimensional model of the molded product 30 is displayed. In another example, keywords related to the relationship objects 33 to be displayed may be provided in the format of a check box. Alternatively, it is conceivable to provide references for every position in the molded product 30, every size and color of arrow objects, or the like on the screen on which the three-dimensional model of the molded product 30 is displayed. In addition, the selection screen separately displayed by the display unit 71 during filtering is not limited to the examples given here.

Additionally, the display unit 71 displays the three-dimensional model of the molded product 30 as a simplified model by combining a plurality of planes, and displays the relationship object 33 with an arrow object at a corresponding position of the simplified model.

Fig. 24 is a diagram displaying the three-dimensional model of the molded product 30 as a simplified model by combining a plurality of planes. In order to visualize the warpage or twist of the entire molded product 30, the relationship objects 33 are displayed together with the three-dimensional model at the corresponding positions obtained by dividing a bounding box (boundary box circumscribing the three-dimensional model) of the three-dimensional model of the molded product 30 as a target to be determined for finish in a grid pattern.

Differences in the respective inspection items are calculated from the standard values of the inspection table, the tolerance range (allowable range), and measurement values, the average values of the quantities and directions of the differences in the identical axial direction of the inspection items belonging to the positions of the respective divided blocks on the three-dimensional model are calculated from the calculated differences, and arrow objects based on the calculated average values of the differences are displayed as the relationship objects 33 at corresponding positions on the surface of the bounding box of the three-dimensional model. The arrow objects displayed at the corresponding positions on the surface of the bounding box of the three-dimensional model cause the arrow objects to be displayed outside the bounding box of the three-dimensional model.

Additionally, as shown in Fig. 24, in a case where the three-dimensional model of the molded product 30 is displayed as a simplified model by combining a plurality of planes and the relationship objects 33 are displayed by arrows at corresponding positions of the simplified model, the directions of the differences are expressed by the orientations of the arrow objects, and the quantities of the differences are displayed by the lengths of the arrow objects or the colors determined in accordance with the quantities of the differences. Moreover, numerical values representing the sizes of the quantities of the differences may be displayed together with the arrow objects, or the quantities of the differences may be displayed in both the lengths and colors of the arrow objects. In order to distinguish between a case where there is no inspection item belonging to the positions of the blocks on the three-dimensional model and a case where the quantities of the differences are 0, for example, small balls may be displayed in the case where the quantities of the differences are 0, and the legends of the lengths or colors of the arrows indicating the quantities of the differences may be displayed.

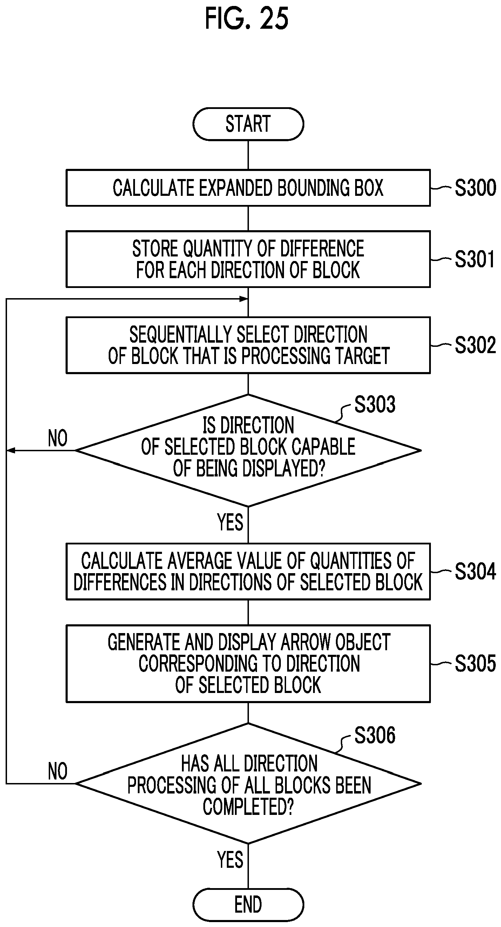

Fig. 25 is a flowchart showing the processing of the information processing apparatus 60 according to the exemplary embodiment of the invention. The description of common points between the processing shown in Fig. 12 and Fig. 18 and the basic processing of the information processing apparatus 60 according to the exemplary embodiment of the invention will be omitted. Fig. 25 illustrates the processing of the information processing apparatus 60 in a case where the entire molded product 30 is displayed in a simplified model by combining a plurality of planes.

In Step S300, the CPU 11, as the acquisition unit 70, calculates an expanded bounding box in which the bounding box of the three-dimensional model of the molded product 30 is expanded to a size divisible by a specified division size L. Specifically, assuming that the width, depth, and height of the bounding box are w0, d0, h0, and the reference point coordinates of the bounding box are x0, y0, z0, the width, depth, and height of the expanded bounding box are w, d, h, and the reference point coordinates (x, y, z) are as follows. In addition, it is assumed that INT (x) is a function that truncates values after the decimal point of x.

$$w = (INT(w0/L) +1)*L, \ x = x0 + (w0 - w)/2$$

$$d = (INT(d0/L) + 1)*L, \ y = y0 + (d0 - d)/2$$

$$h = (INT(h0/L) + 1)*L, \ z = z0 + (h0 - h)/2$$

In Step S301, the CPU 11, as the acquisition unit 70, stores the quantities of differences for respective directions of a block. Specifically, the quantity of difference is stored in each of the X-axis direction, Y-axis direction, and Z-axis direction of a block (any of w × d × h blocks) of the expanded bounding box to which the starting point coordinates of the dimensional tolerance of a datum reference belong.

In Step S302, the CPU 11, as the acquisition unit 70, sequentially selects the direction of a block that is a processing target.

In Step S303, the CPU 11 determines whether or not the direction of the block selected in the previous Step S302 can be displayed by the acquisition unit 70. Whether or not the direction of the block can be displayed determines whether or not the direction is on the surface of the expanded bounding box among the faces of the block selected in the previous Step S302 and is an outward direction of a face of the block. In a case where the direction of the block selected in the previous Step S302 can be displayed, the processing proceeds to Step S304. In a case where the direction of the block selected in the previous Step S302 cannot be displayed, the processing returns to Step S302.

In Step S304, the CPU 11 as the acquisition unit 70, calculates the average value of the quantities of the differences in the directions of the block selected in the previous Step S302.

In Step S305, the CPU 11, as the display unit 71, generates and displays an arrow object corresponding to the direction of the block selected in the previous Step S302. The orientation and size of the arrow object are determined by sequentially processing the quantity of difference stored for each direction of an individual block selected in the previous Step S302. The direction that can be displayed in a target block selected in the previous Step S302 is determined, and an arrow object is generated and displayed in a direction that can be displayed from the center position of a face of the block. The orientation of the arrow object is determined in conformity with the positive or negative of the quantity of difference. For example, in a case where the quantity of difference is negative, the direction of the arrow object is a direction toward the inside of the expanded bounding box, and in a case where the quantity of difference is positive, the direction of the arrow object is a direction toward the outside from the expanded bounding box.

In Step S306, the CPU 11, as the acquisition unit 70, determines whether or not the direction processing of all the blocks in the previous Step S305 has been completed. In a case where the direction processing of all the blocks is completed in the previous Step S305, the processing ends. On the other hand, in a case where the direction processing of all the blocks is not completed in the previous Step S305, the processing returns to Step S302 and the same processing is repeated.

As described above, according to the information processing apparatus 60 according to the exemplary embodiment of the invention, in a case where the three-dimensional model of the entire molded product 30 displaying the relationship objects 33 are displayed, it is possible to easily visually recognize the positional relationship of at least two or more measurement spots 32 in the molded product 30 on the three-dimensional model of the molded product 30, in a state where the relationship objects 33 unnecessary for the user are omitted. Additionally, by displaying the relationship objects 33 together with the three-dimensional model at the corresponding positions obtained by dividing the bounding box of the three-dimensional model of the molded product 30 in a grid pattern, it is possible to visualize the tendency of the warpage or twist of the entire molded product 30 rather than an acceptance/rejection for each detailed standard, and the finished state of the actually manufactured molded product 30 may be visually recognized more clearly.

In the exemplary embodiment of the invention, a form in which the information processing program is installed in the storage unit 13 has been described, but the exemplary embodiment of the invention is not limited to this. The information processing program according to the exemplary embodiment of the invention may be provided in a form in which the information processing program is recorded on a computer-readable storage medium. For example, the information processing program according to the exemplary embodiment of the invention is may be provided in a form in which the information processing program is recorded on optical disks such as a compact disc (CD) -ROM and a digital versatile disc (DVD) -ROM, or a form in which the information processing program is recorded on semiconductor memories such as a universal serial bus (USB) memory and a memory card. Additionally, the information processing program according to the exemplary embodiment of the invention may be acquired from an external device via a communication line connected to the communication I/F 14.

In the embodiments above, the term "processor" refers to hardware in a broad sense. Examples of the processor include general processors (e.g., CPU: Central Processing Unit) and dedicated processors (e.g., GPU: Graphics Processing Unit, ASIC: Application Specific Integrated Circuit, FPGA: Field Programmable Gate Array, and programmable logic device).

In the embodiments above, the term "processor" is broad enough to encompass one processor or plural processors in collaboration which are located physically apart from each other but may work cooperatively. The order of operations of the processor is not limited to one described in the embodiments above, and may be changed.

The foregoing description of the exemplary embodiments of the present invention has been provided for the purposes of illustration and description. It is not intended to be exhaustive or to limit the invention to the precise forms disclosed. Obviously, many modifications and variations will be apparent to practitioners skilled in the art. The embodiments were chosen and described in order to best explain the principles of the invention and its practical applications, thereby enabling others skilled in the art to understand the invention for various embodiments and with the various modifications as are suited to the particular use contemplated. It is intended that the scope of the invention be defined by the following claims and their equivalents.

Brief Description of the Reference Symbols

10, 40, 60:    information processing apparatus
11:            CPU
12:            memory
13:            storage unit
14:            communication I/F
15:            input and output I/F
16:            input unit
17:            output unit
18:            storage medium reading device
20, 50, 70:    acquisition unit
21, 51, 71:    display unit
30:            molded product
31:            inspection target
32:            measurement spot
33 to 35:      relationship object
36:            guide line
XX:            relationship object showing contour degree

**Claims**

1. An information processing apparatus comprising:
   a processor configured to:
   display a relationship object indicating a positional relationship of at least two or more measurement spots in a molded product at a position corresponding to the relationship on a three-dimensional model of the molded product.

2. The information processing apparatus according to claim 1, wherein the processor is configured to:
   display, as the relationship object, a first relationship object indicating a positional relationship of at least two or more measurement spots in the molded product, and a second relationship object indicating a positional relationship between the first relationship object and at least one or more measurement spots in the molded product, at positions corresponding to the relationships on the three-dimensional model of the molded product.

3. The information processing apparatus according to claim 1, wherein the processor is configured to:
   display, as the relationship object, a third relationship object indicating a positional relationship of at least two or more measurement spots in the molded product, a fourth relationship object indicating a positional relationship of at least two or more measurement spots in the molded product separately from the third relationship object, and a fifth relationship object indicating a positional relationship between the third relationship object and the fourth relationship object, at positions corresponding to the relationships on the three-dimensional model of the molded product.

4. The information processing apparatus according to any one of claims 1 to 3,
wherein the relationship object displays the positional relationship by forming a line or face including two or more measurement spots.

5. The information processing apparatus according to any one of claims 1 to 4,
wherein the positional relationship is acquired by a measurement based on an analog technique.

6. The information processing apparatus according to any one of claims 1 to 5,
wherein the positional relationship is acquired from a coordinate position obtained by measuring two or more measurement spots in the molded product.

7. The information processing apparatus according to any one of claims 1 to 6, wherein the processor is configured to:
acquire design information on a design of the molded product, and acquire comparison information obtained by comparing the design information with the positional relationship.

8. The information processing apparatus according to claim 7, wherein the processor is configured to:
display at least one of a quantity of a difference or a direction of the difference, which is a result obtained by comparing the positional relationship with the design information, in a color or an arrow that is the relationship object.

9. The information processing apparatus according to any one of claims 1 to 8,
wherein the measurement spots are acquired from a position of a center of gravity of a shape element that is an inspection target in the molded product.

10. The information processing apparatus according to any one of claims 1 to 9, wherein the processor is configured to:
independently display a plurality of the relationship objects on the first inspection target for every plurality of corresponding measurement spots of the first inspection target and the second inspection target in a case where a plurality of the measurement spots are present in each of a first inspection target and a second inspection target in the molded product.

11. The information processing apparatus according to claim 9 or 10, wherein the processor is configured to:
compare the first inspection target with the second inspection target, and determine a display position of the relationship object in accordance with a position of a center of gravity of the smaller inspection target in a case where a plurality of the second inspection targets corresponding to the first inspection target are present.

12. The information processing apparatus according to claim 10 or 11, wherein the processor is configured to:
display at least one of the design information or the comparison information possessed by the relationship object in a case where the relationship object is selected.

13. The information processing apparatus according to claim 12, wherein the processor is configured to:
display, simultaneously with the relationship object, another relationship object related to another inspection, which is performed on the inspection target and are also related to the comparison information.

14. The information processing apparatus according to claim 13, wherein the processor is configured to:
display a plurality of the relationship objects in a manner that the relationship objects are capable of being distinguished from each other.

15. The information processing apparatus according to any one of claims 1 to 14, wherein the processor is configured to:
filter and display the relationship object to be displayed on the three-dimensional model among all the relationship objects related to the molded product.

16. The information processing apparatus according to any one of claims 1 to 15, wherein the processor is configured to:
display the three-dimensional model as a simplified model by combining a plurality of planes, and display the relationship object with an arrow at a corresponding position of the simplified model.

**17.** The information processing apparatus according to any one of claims 1 to 16, wherein the processor is configured to: determine a reference value used for an acceptance/rejection determination of the molded product, which is calculated on the basis of the design information, in correspondence with a user's selection or attribute information possessed by the user.

**18.** An information processing program making a computer to execute a process comprising: displaying a relationship object indicating a positional relationship of at least two or more measurement spots in a molded product, at a position corresponding to the relationship on a three-dimensional model of the molded product.

**19.** An information processing method comprising: displaying a relationship object indicating a positional relationship of at least two or more measurement spots in a molded product, at a position corresponding to the relationship on a three-dimensional model of the molded product.

FIG. 1

# FIG. 2

# FIG. 3

10, 40, 60

ACQUISITION
UNIT — 20, 50, 70

DISPLAY UNIT — 21, 51, 71

# FIG. 4

A

10

15

$\phi 6 \pm 0.1$

| ⊕ | $\phi$ 0.1 | A | B |

B

## FIG. 5

## FIG. 6

# FIG. 7

# FIG. 8

## FIG. 9

## FIG. 10A

31A

33

31B

32

## FIG. 10B

31A

32

33

31B

# FIG. 11

(A)

METHOD OF DETERMINING REFERENCE VALUE

◉ USE STANDARD VALUE

○ USE TOLERANCE MEDIAN

(B)

| TOLERANCE LOWER LIMIT VALUE | REFERENCE VALUE<br>=<br>STANDARD VALUE | TOLERANCE UPPER LIMIT VALUE |

(C)

| TOLERANCE LOWER LIMIT VALUE | REFERENCE VALUE<br>=<br>TOLERANCE MEDIAN | TOLERANCE UPPER LIMIT VALUE |

EP 4 068 219 A1

# FIG. 12

```
                    ┌─────────────┐
                    │    START    │
                    └─────────────┘
                           │
        ┌──────────────────────────────────────┐
        │      ACQUIRE DESIGN INFORMATION       │── S100
        └──────────────────────────────────────┘
                           │
        ┌──────────────────────────────────────┐
        │  ACQUIRE INFORMATION ON INSPECTION RESULTS │── S101
        └──────────────────────────────────────┘
                           │
        ┌──────────────────────────────────────┐
        │   ACQUIRE ATTRIBUTE INFORMATION OF USER    │── S102
        └──────────────────────────────────────┘
                           │
        ┌──────────────────────────────────────┐
        │        DETERMINE REFERENCE VALUE      │── S103
        └──────────────────────────────────────┘
                           │
        ┌──────────────────────────────────────┐
        │                COMPARE                │── S104
        └──────────────────────────────────────┘
                           │
        ┌──────────────────────────────────────┐
        │ SPECIFY DISPLAY POSITION INDICATING POSITIONAL │── S105
        │ RELATIONSHIP OF AT LEAST TWO OR MORE       │
        │ MEASUREMENT SPOTS IN MOLDED PRODUCT        │
        └──────────────────────────────────────┘
                           │
        ┌──────────────────────────────────────┐
        │      GENERATE RELATIONSHIP OBJECT     │── S106
        └──────────────────────────────────────┘
```

S107 — IS MOLDED PRODUCT WITHIN ALLOWABLE RANGE?

NO — S108 GENERATE AND DISPLAY RELATIONSHIP OBJECT REPRESENTING DIRECTION OF DIFFERENCE

GENERATE AND DISPLAY RELATIONSHIP OBJECT REPRESENTING QUANTITY OF DIFFERENCE — S109

YES

S110 — HAVE RELATIONSHIP OBJECTS BEEN GENERATED AND DISPLAYED FOR ALL INSPECTIONS?

NO

YES

END

## FIG. 13

# FIG. 14

EP 4 068 219 A1

FIG. 15

EP 4 068 219 A1

FIG. 16

EP 4 068 219 A1

# FIG. 17

# FIG. 18

```
                    ┌─────────┐
                    │  START  │
                    └────┬────┘
                         │
     ┌───────────────────┴──────────────────────┐
     │ EXTRACT ALL SECOND INSPECTION TARGETS     │── S200
     │ CORRESPONDING TO FIRST INSPECTION TARGET  │
     └───────────────────┬──────────────────────┘
                         │
     ┌───────────────────┴──────────────────────┐
     │ COMPARE ALL EXTRACTED SECOND INSPECTION   │── S201
     │ TARGETS WITH FIRST INSPECTION TARGET      │
     └───────────────────┬──────────────────────┘
                         │
     ┌───────────────────┴──────────────────────┐
     │ EXTRACT SMALLEST INSPECTION TARGET        │── S202
     └───────────────────┬──────────────────────┘
                         │
     ┌───────────────────┴──────────────────────┐
     │ GENERATE RELATIONSHIP OBJECT FROM POSITION│── S203
     │ OF CENTER OF GRAVITY                       │
     │ OF EXTRACTED SMALLEST INSPECTION TARGET    │
     └───────────────────┬──────────────────────┘
```

S204
HAVE DISPLAY RELATIONSHIP OBJECTS BEEN DISPLAYED FOR ALL INSPECTION TARGETS?

NO

YES

S205
ACQUIRE INFORMATION ON CERTAIN RELATIONSHIP OBJECT 33 THAT USER HAS SELECTED

S206
DISPLAY AT LEAST ONE OF DESIGN INFORMATION OR COMPARISON INFORMATION ON RELATIONSHIP OBJECT

S207
ARE OTHER RELATIONSHIP OBJECTS RELATED TO RELATIONSHIP OBJECT PRESENT?

YES

NO

S208
DISPLAY OTHER RELATIONSHIP OBJECTS RELATED TO RELATIONSHIP OBJECT IN SUCH MANNER THAT RELATIONSHIP OBJECTS CAN BE DISTINGUISHED FROM EACH OTHER

END

FIG. 19

FIG. 20

DATUM A

DATUM B

DATUM C

Z

X

Y

FIG. 21

FIG. 22

## FIG. 23

## FIG. 24

# FIG. 25

START

CALCULATE EXPANDED BOUNDING BOX — S300

STORE QUANTITY OF DIFFERENCE
FOR EACH DIRECTION OF BLOCK — S301

SEQUENTIALLY SELECT DIRECTION
OF BLOCK THAT IS PROCESSING TARGET — S302

IS DIRECTION
OF SELECTED BLOCK CAPABLE
OF BEING DISPLAYED? — S303

NO

YES

CALCULATE AVERAGE VALUE OF QUANTITIES OF
DIFFERENCES IN DIRECTIONS OF SELECTED BLOCK — S304

GENERATE AND DISPLAY ARROW OBJECT
CORRESPONDING TO DIRECTION
OF SELECTED BLOCK — S305

HAS ALL DIRECTION
PROCESSING OF ALL BLOCKS BEEN
COMPLETED? — S306

NO

YES

END

Europäisches
Patentamt

European
Patent Office

Office européen
des brevets

# EUROPEAN SEARCH REPORT

Application Number

EP 21 19 4222

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 1 233 376 A2 (CANON KK [JP]) 21 August 2002 (2002-08-21) * abstract * * * paragraph [0144] * ----- | 1-19 | INV. G06T19/00 |
| X | WO 2018/151212 A1 (HONDA MOTOR CO LTD [JP]) 23 August 2018 (2018-08-23) * abstract * * * paragraph [0032] * ----- | 1-19 | |

**TECHNICAL FIELDS SEARCHED (IPC)**

G06T

The present search report has been drawn up for all claims

| Place of search | Date of completion of the search | Examiner |
|---|---|---|
| Berlin | 16 February 2022 | González Arias, P |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
.......................................................
& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 21 19 4222

This annex lists the patent family members relating to the patent documents cited in the above-mentioned European search report.
The members are as contained in the European Patent Office EDP file on
The European Patent Office is in no way liable for these particulars which are merely given for the purpose of information.

16-02-2022

| Patent document cited in search report | | Publication date | Patent family member(s) | | Publication date |
|---|---|---|---|---|---|
| EP 1233376 | A2 | 21-08-2002 | CN | 1383083 A | 04-12-2002 |
| | | | CN | 1900976 A | 24-01-2007 |
| | | | EP | 1233376 A2 | 21-08-2002 |
| | | | KR | 20020068289 A | 27-08-2002 |
| | | | US | 2002149625 A1 | 17-10-2002 |
| | | | US | 2005225551 A1 | 13-10-2005 |
| WO 2018151212 | A1 | 23-08-2018 | CN | 110300968 A | 01-10-2019 |
| | | | JP | 6735367 B2 | 05-08-2020 |
| | | | JP | WO2018151212 A1 | 12-12-2019 |
| | | | WO | 2018151212 A1 | 23-08-2018 |

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 6735367 B